# EUROPEAN PATENT APPLICATION

(11) **EP 2 544 219 A1**
(43) Date of publication of application: **09.01.2013**
(21) Application number: 11750812.7
(22) Date of filing: 04.03.2011
(51) Int. Cl.: H01L 21/20, C30B 29/20, C30B 33/02, H01L 21/268

(54) **SINGLE CRYSTAL SUBSTRATE WITH MULTILAYER FILM, PRODUCTION METHOD FOR SINGLE CRYSTAL SUBSTRATE WITH MULTILAYER FILM, AND DEVICE PRODUCTION METHOD**

(30) Priority: 05.03.2010 JP 2010049858
(71) Applicant: Namiki Seimitsu Houseki kabushikikaisha, Adachi-ku Tokyo 123-8511 (JP); Disco Corporation, Tokyo 143-8580 (JP)
(72) Inventor: AIDA, Hideo, Tokyo 123-8511 (JP); AOTA, Natsuko, Tokyo 123-8511 (JP); HOSHINO, Hitoshi, Tokyo 143-8580 (JP); FURUTA, Kenji, Tokyo 143-8580 (JP); HAMAMOTO, Tomosaburo, Tokyo 143-8580 (JP); HONJO, Keiji, Tokyo 143-8580 (JP)
(74) Representative: Skone James, Robert Edmund
(86) International application number: PCT/JP2011/055066
(87) International publication number: WO 2011/108703

(57) **Abstract**

In order to correct warpage that occurs in formation of a multilayer film, provided are a single crystal substrate with a multilayer film, a manufacturing method therefor, and an element manufacturing method using the manufacturing method. The single crystal substrate with a multilayer film includes: a single crystal substrate (20); a multilayer film (30) including two or more layers that is formed on one surface of the single crystal substrate (20) and having a compressive stress; and a heat-denatured layer (22) provided, of two regions (20U, 20D) obtained by bisecting the single crystal substrate (20) in the thickness direction thereof, at least in the region (20D) on the side of the surface opposite to the one surface of the single crystal substrate (20) having the multilayer film (30) formed thereon.

## Description

### Technical Field

The present invention relates to a single crystal substrate with a multilayer film, a manufacturing method for a single crystal substrate with a multilayer film, and an element manufacturing method.

### Background Art

A nitride semiconductor represented by gallium nitride (GaN) has a wide band gap and is capable of blue light emission, and hence the nitride semiconductor is widely used in a light emitting diode (LED), a semiconductor laser (LD), and the like. In recent years, an effort to further increase the luminous efficiency and luminance has been actively made.

The structure of a typical nitride semiconductor light emitting element has a double hetero structure in which, on a sapphire substrate, a buffer layer made of GaN, an n-type contact layer made of n-type GaN, an n-type cladding layer made of n-type AlGaN, an active layer made of n-type InGaN, a p-type cladding layer made of p-type AlGaN, and a p-type contact layer made of p-type GaN are laminated in this order. The active layer contains In of a single quantumwell (SQW) structurehavingonlyawell layer made of InxGa1-xN (0≤X≤1) or a multi-quantum well (MQW) structure having the well layer made of InxGa1-xN (0≤X≤1) and a barrier layer made of InyGa1-yN (0≤y≤1, y<x) (see Patent Literature 1).

It is known that, when the above-mentioned multilayer film is formed on the sapphire substrate, warpage occurs in the sapphire substrate after the film formation due to differences in thermal expansion coefficient and lattice constant between the multilayer film and sapphire. For example, Non Patent Literature 1 discloses the result of a study in which an AlN buffer layer and a GaN layer are epitaxially grown on a sapphire substrate to determine how a thermal stress generated by the film formation is relieved depending on the film thickness of the GaN layer. Non Patent Literature 1 reveals that the warpage of the substrate is increased as the film thickness is increased, and interference defects, microcracks, dislocation, or macrocracks occur correspondingly to the increase, and accordingly the stress is relieved.

In addition, FIG. 4 of Non Patent Literature 2 discloses an analysis method in which the warpage of a substrate occurring through the step of epitaxially growing a GaN-based LED structure on a sapphire substrate is observed in situ. According to this method, it is revealed that, in a series of film formation steps, the curvature of the sapphire substrate significantly changes due to changes in film forming substance, film formation temperature, and film thickness. Further, it is revealed that, by adopting the film formation steps that allow the curvature of the sapphire substrate to become substantially 0 at the stage of the growth of the InGaN layer as the active layer, the emission wavelength in the surface of the substrate is uniformed.

As has been described above, it is known that the warpage of the sapphire substrate significantly changes through a series of film formation steps, and the quality of the nitride semiconductor film and the uniformity of the emission wavelength are thereby affected. Note that, in reality, the warpage shape and the warpage amount of the sapphire substrate are often set so that the substrate curvature becomes substantially 0 in the InGaN-based active layer by utilizing a difference in thermal expansion coefficient from that of the substrate. With the background described above, in order to control the shape and the warpage amount of the sapphire substrate, various polishing technologies are studied (see Patent Literature 2 and the like).

On the other hand, a technology is known in which, when a light emitting element obtained by laminating nitride semiconductor on a sapphire substrate is divided, a pulsed laser is concentrated onto the internal portion of the sapphire substrate having a thickness of about 80 µm to 90 µm to form a reformed region corresponding to a line for division of the light emitting element (Patent Literature 3). The technology disclosed in Patent Literature 3 is a method of processing the sapphire substrate capable of suppressing a reduction in the luminance of the light emitting element even when the substrate is divided into the individual light emitting elements by applying a laser beam to the sapphire substrate, and an object of the technology is the division of the light emitting element.

### Citation List

### Patent Literature

[PTL 1] JP 3250438 B
[PTL 2] JP 2006-347776 A
[PTL 3] JP 2008-6492 A

### Non Patent Literature

[NPL 1] Jpn. J. Appl. Phys., Vol. 32, (1993), pp. 1528-1533
[NPL 2] J. Cryst. Growth, Vol. 272, Issues 1-4, (2004), pp. 94-99

### Summary of Invention

### Technical Problem

As has been described above, when, in order to produce various elements such as the light emitting element, the multilayer film in accordance with the element structure is formed on a single crystal substrate such as the sapphire substrate, the substrate after the film formation (single crystal substrate with a multilayer film) is usually warped. On the other hand, in the manufacturing of the element, various subsequent steps are usually further performed on the single crystal substrate with a multilayer film. However, when the subsequent steps are performed in a state in which the substrate with a multilayer film is warped, this has led to variations in quality and a reduction in yield of the element.

For example, when a patterning process is performed on the multilayer film in the subsequent step, the following problem occurs. That is, when the patterning process is performed on the multilayer film, a resist formed on the multilayer film is exposed by using a photomask. At this time, the single crystal substrate with a multilayer film is in a warped state. Therefore, when the focal point of light irradiated for the exposure is set on the surface of the multilayer film positioned at the central portion of the single crystal substrate, the surface of the multilayer film positioned in the vicinity of the end portion of the single crystal substrate becomes out of focus. In this case, variations in exposure occur in the surface of the multilayer film, which lead to variations in quality and a reduction in yield of the element manufactured by performing the subsequent steps.

In addition, in the subsequent step, when the surface of the single crystal substrate with a multilayer film opposite to the surface having the multilayer film formed thereon is to be polished (back lapping process), the surface of the single crystal substrate with a multilayer film having the multilayer film formed thereon needs to be bonded and fixed to a flat polishing board. However, in this case, when the single crystal substrate with a multilayer film is warped, in order to flatten the surface to be subjected to the back lapping process, it is necessary for the bonding process to apply a large pressure to the single crystal substrate with a multilayer film at the time of the bonding. However, as the warpage becomes larger, a larger pressure needs to be applied. As a result, a crack becomes likely to occur in the substrate with a multilayer film, and the yield is thereby reduced. In order to avoid the occurrence of the above-mentioned problem, it can be conceived to use a thicker single crystal substrate. However, in this method, a polishing amount required for the back lapping process is increased and a polishing time period is prolonged, and hence productivity is lowered and the method lacks practicality.

In view of the above-mentioned circumstances, it can be said that it is preferable that, in the single crystal substrate with a multilayer film, the warpage resulting from the formation of the multilayer film be corrected before the subsequent step is performed so that the single crystal substrate with a multilayer film becomes as flat as possible.

The present invention has been made in view of the above-mentioned circumstances, and therefore has an object to provide a single crystal substrate with a multilayer film in which warpage resulting from the formation of the multilayer film is corrected, a manufacturing method for the single crystal substrate with a multilayer film, and an element manufacturing method using the manufacturing method.

### Solution to Problem

The above-mentioned object is attained by the present invention as follows.
Specifically, according to the present invention, there is provided a single crystal substrate with a multilayer film, including: a single crystal substrate; a multilayer film including two or more layers that is formed on one surface of the single crystal substrate; and a heat-denatured layer provided, of two regions obtained by bisecting the single crystal substrate in a thickness direction of the single crystal substrate, at least in the region on a side of a surface of the single crystal substrate opposite to the one surface having the multilayer film formed thereon.

In a single crystal substrate with a multilayer film according to an embodiment of the present invention, the heat-denatured layer is preferably formed by laser irradiation to the single crystal substrate.

In a single crystal substrate with a multilayer film according to another embodiment of the present invention, the heat-denatured layer is preferably provided in parallel to the multilayer film.

In a single crystal substrate with a multilayer film according to still another embodiment of the present invention, when a relative position of the heat-denatured layer in a thickness direction of the single crystal substrate is assumed to be 0% at the one surface provided with the multilayer film and 100% at a surface opposite to the one surface provided with the multilayer film, the heat-denatured layer is preferably provided in a range of more than 50% and 95% or less in the thickness direction of the single crystal substrate.

In a single crystal substrate with a multilayer film according to still another embodiment of the present invention, in a planar direction of the single crystal substrate, the heat-denatured layer is preferably provided to have at least one pattern shape selected from the following shapes:
i) a shape in which a plurality of polygons identical in shape and size are regularly disposed;
ii) a shape inwhichapluralityof circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

In a single crystal substrate with a multilayer film according to still another embodiment of the present invention, the shape in which the plurality of polygons identical in shape and size are regularly disposed is preferably a lattice shape.

In a single crystal substrate with a multilayer film according to still another embodiment of the present invention, the lattice shape is preferably formed of a pattern in which a pitch between lines constituting the pattern is in a range of 50 µm to 2,000 µm.

In a single crystal substrate with a multilayer film according to still another embodiment of the present invention, when a relative position of the heat-denatured layer in a thickness direction of the single crystal substrate is assumed to be 0% at the one surface provided with the multilayer film and 100% at a surface opposite to the one surface provided with the multilayer film, the second heat-denatured layer is preferably provided in a range of 0% or more and less than 50% in the thickness direction of the single crystal substrate.

In a single crystal substrate with a multilayer film according to still another embodiment of the present invention, a material of the single crystal substrate is preferably sapphire.

In a single crystal substrate with a multilayer film according to still another embodiment of the present invention, the single crystal substrate preferably has a diameter of 50 mm or more and 300 mm or less.

In a single crystal substrate with a multilayer film according to still another embodiment of the present invention, the single crystal substrate preferably has a thickness of 0.05 mm or more and 5.0 mm or less.

In a single crystal substrate with a multilayer film according to still another embodiment of the present invention, at least one of the two or more layers constituting the multilayer film is preferably a nitride semiconductor crystal layer.

In a single crystal substrate with a multilayer film according to still another embodiment of the present invention, the multilayer film is preferably subjected to at least a patterning process so as to enable production of an element selected from the group consisting of a light emitting element, a photovoltaic element, and a semiconductor element.

According to the present invention, there is provided a manufacturing method for a single crystal substrate with a multilayer film, including performing at least a heat-denatured layer formation step after multilayer film formation in which, of two regions obtained by bisecting, in a thickness direction of a single crystal substrate, the single crystal substrate having one surface on which a multilayer film including two or more layers and having a compressive stress is formed, a heat-denatured layer is formed at least in the region on a side of a surface of the single crystal substrate opposite to the one surface having the multilayer film formed thereon by irradiating a laser from the side of the surface opposite to the one surface of the single crystal substrate having the multilayer film formed thereon.

In a manufacturing method for a single crystal substrate with a multilayer film according to an embodiment of the present invention, it is preferred to perform the laser irradiation so as to satisfy at least one of irradiation conditions A and B described below.

### <Irradiation Condition A>

·laser wavelength: 200 nm to 350 nm
·pulse width: order of nanoseconds

### <Irradiation Condition B>

·laser wavelength: 350 nm to 2,000 nm
·pulse width: order of femtoseconds to order of picoseconds

In a manufacturing method for a single crystal substrate with a multilayer film according to another embodiment of the present invention, it is preferred to form the heat-denatured layer so as to be in parallel to the multilayer film.

In a manufacturing method for a single crystal substrate with a multilayer film according to still another embodiment of the present invention, it is preferred to form the heat-denatured layer to be positioned, when a relative position of the heat-denatured layer in the thickness direction of the single crystal substrate is assumed to be 0% at the one surface provided with the multilayer film and 100% at a surface opposite to the one surface provided with the multilayer film, in a range of more than 50% and 95% or less in the thickness direction of the single crystal substrate.

In a manufacturing method for a single crystal substrate with a multilayer film according to still another embodiment of the present invention, it is preferred to form, in a planar direction of the single crystal substrate, the heat-denatured layer so as to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

In a manufacturing method for a single crystal substrate with a multilayer film according to still another embodiment of the present invention, the shape in which the plurality of polygons identical in shape and size are regularly disposed is preferably a lattice shape.

In a manufacturing method for a single crystal substrate with a multilayer film according to still another embodiment of the present invention, it is preferred to form the lattice shape into a pattern in which a pitch between lines constituting the pattern is in a range of 50 µm to 2,000 µm.

In a manufacturing method for a single crystal substrate with a multilayer film according to still another embodiment of the present invention, it is preferred to perform at least:
(1) a heat-denatured layer formation step before multilayer film formation in which, by irradiating the laser from a side of the one surface of the single crystal substrate, when a relative position of a heat-denatured layer in the thickness direction of the single crystal substrate is assumed to be 0% at the one surface on the side from which the laser is irradiated and 100% at the surface opposite to the one surface on the side from which the laser is irradiated, the heat-denatured layer is formed so as to be positioned in a range of 0% or more and less than 50% in the thickness direction of the single crystal substrate;
(2) a multilayer film formation step in which the multilayer film including the two or more layers and having the compressive stress is formed on the surface of the single crystal substrate on the side from which the laser is irradiated, the single crystal substrate having the heat-denatured layer formed therein; and
(3) the heat-denatured layer formation step after multilayer film formation.

In a manufacturing method for a single crystal substrate with a multilayer film according to still another embodiment of the present invention, a material of the single crystal substrate is preferably sapphire.

In a manufacturing method for a single crystal substrate with a multilayer film according to still another embodiment of the present invention, the single crystal substrate preferably has a diameter of 50 mm or more and 300 mm or less.

In a manufacturing method for a single crystal substrate with a multilayer film according to still another embodiment of the present invention, the single crystal substrate preferably has a thickness of 0.05 mm or more and 5.0 mm or less.

In a manufacturing method for a single crystal substrate with a multilayer film according to still another embodiment of the present invention, at least one of the two or more layers constituting the multilayer film is preferably a nitride semiconductor crystal layer.

According to the present invention, there is provided an element manufacturing method, including: performing at least a heat-denatured layer formation step after multilayer film formation in which, of two regions obtained by bisecting, in a thickness direction of a single crystal substrate, the single crystal substrate having one surface on which a multilayer film including two or more layers and having a compressive stress is formed, a heat-denatured layer is formed at least in the region on a side of a surface opposite to the one surface of the single crystal substrate having the multilayer film formed thereon by irradiating a laser from the side of the surface of the single crystal substrate opposite to the one surface having the multilayer film formed thereon, thereby manufacturing the single crystal substrate with a multilayer film; and performing at least an element portion formation step of performing at least a patterning process on the multilayer film of the single crystal substrate with a multilayer film to produce an element portion functioning as an element selected from the group consisting of a light emitting element, a photovoltaic element, and a semiconductor element, thereby manufacturing an element including the element portion and the single crystal substrate having a size substantially corresponding to a size of the element portion.

### Advantageous Effects of Invention

According to the present invention described above, it is possible to provide the single crystal substrate with a multilayer film in which the warpage resulting from the formation of the multilayer film is corrected, the manufacturing method for the single crystal substrate with a multilayer film, and the element manufacturing method using the manufacturing method.

### Brief Description of Drawings

[FIG. 1] A schematic explanatory diagram illustrating an example of a manufacturing method for a single crystal substrate with a multilayer film according to an embodiment of the present invention.
[FIG. 2] A schematic explanatory diagram illustrating the example of the manufacturing method for a single crystal substrate with a multilayer film according to the embodiment of the present invention, corresponding to the example illustrated in FIG. 1.

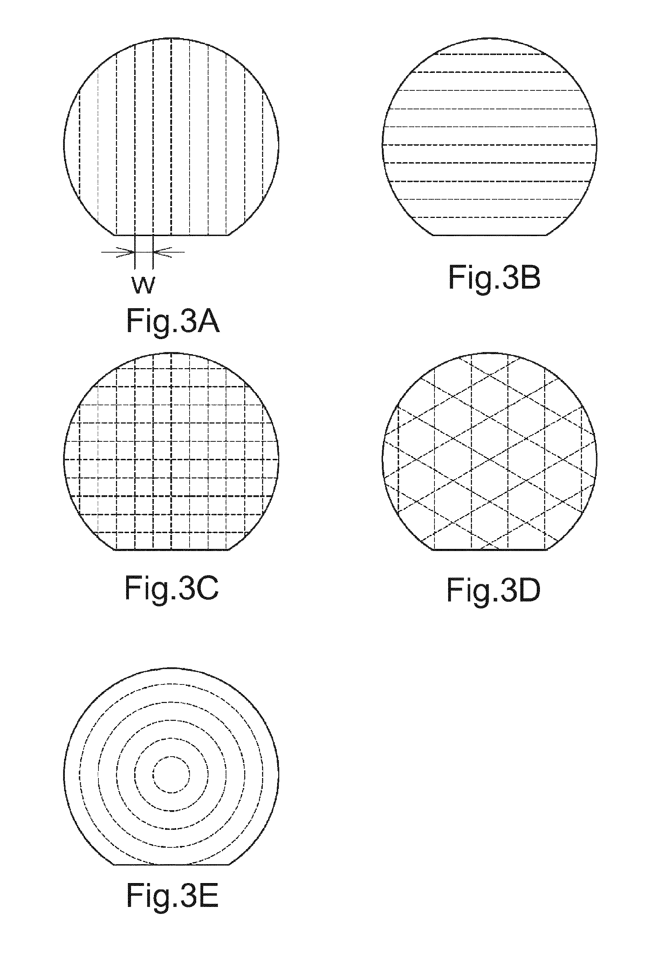

[FIGS. 3] Plan views illustrating examples of a disposition pattern shape of a heat-denatured layer in a planar direction of a single crystal substrate, of which FIG. 3A is a plan view illustrating a stripe shape in which a plurality of lines are formed perpendicular to an orientation flat plane of a substrate, FIG. 3B is a plan view illustrating a stripe shape in which a plurality of lines are formed in parallel to the orientation flat plane of the substrate, FIG. 3C is a plan view illustrating a lattice shape in which the disposition pattern shapes illustrated in FIGS. 3A and 3B are combined, FIG. 3D is a plan view illustrating a shape in which a plurality of regular hexagons identical in size are regularly disposed so that each of six vertices of each regular hexagon always coincides with any one of vertices of an adjacent regular hexagon, and FIG. 3E is a plan view illustrating a concentric shape.
[FIG. 4] A schematic explanatory diagram illustrating another example of the manufacturing method for a single crystal substrate with a multilayer film according to the embodiment of the present invention.
[FIG. 5] A schematic cross-sectional view illustrating another example of the single crystal substrate with a multilayer film according to the embodiment of the present invention.
[FIGS. 6] Schematic explanatory diagrams illustrating an example of a multilayer film formation step, of which FIG. 6A illustrates a state before film formation is started, FIG. 6B illustrates a state after a low-temperature buffer layer is formed, FIG. 6C illustrates a state after an n-GaN layer is formed, and FIG. 6D illustrates a state after an InGaN-based active layer having a multi-quantum well structure is formed.
[FIG. 7] A graph showing an example of a warpage behavior of the single crystal substrate in the multilayer film formation step.
[FIG. 8] A schematic explanatory diagram illustrating a method of calculating a warpage amount of a substrate from a curvature of the circular substrate.
[FIGS. 9] Schematic explanatory diagrams illustrating an example of an element manufacturing method according to the embodiment of the present invention, of which FIG. 9A illustrates an element portion formation step, FIG. 9B illustrates a polishing step, FIG. 9C illustrates a line-for-division formation step, and FIG. 9D illustrates a division step.
[FIG. 10] A graph showing the warpage amounts caused by laser irradiation, in the single crystal substrates with a multilayer filmhaving similar warpage amounts after formation of the multilayer film, under test conditions of Examples A1 to A5 shown in Table 2.
[FIG. 11] A graph showing the result of evaluation of a relationship of a change amount of the curvature of a sapphire substrate with respect to a thickness direction of the sapphire substrate serving as a formation position of a first heat-denatured layer.

### Reference Signs List

- 10: substrate with a film before laser processing
- 10A: substrate with a film before second laser processing
- 12: substrate with a film after laser processing (single crystal substrate with a multilayer film)
- 12A: substrate with a film after second laser processing (single crystal substrate with a multilayer film)
- 20: single crystal substrate
- 20A: single crystal substrate that has been polished
- 20D: non-film formation surface side region
- 20U: film formation surface side region
- 22, 22A, 22B, 22C, 22D: heat-denatured layer (first heat-denatured layer)
- 24: non-film formation surface
- 24A: non-film formation surface that has been polished
- 26: film formation surface
- 28, 28A, 28B, 28C, 28D: second heat-denatured layer
- 30: multilayer film
- 32: element portion
- 40: laser irradiation apparatus
- 50: sapphire substrate (single crystal substrate)
- 52: film formation surface
- 54: non-film formation surface
- 60: low-temperature buffer layer
- 62: n-GaN layer
- 64: InGaN-based active layer
- 70: multilayer film
- 80: polishing board
- 90: line for division
- 100: element

### Description of Embodiment

### (Single crystal substrate with a multilayer film and manufacturing method therefor)

A single crystal substrate with a multilayer film according to an embodiment of the present invention includes: a single crystal substrate; a multilayer film including two or more layers that is formed on one surface of the single crystal substrate and having a compressive stress before formation of a heat-denatured layer; and the heat-denatured layer provided, of two regions obtained by bisecting the single crystal substrate in a thickness direction thereof, at least in the region on a side of a surface of the single crystal substrate opposite to the one surface having the multilayer film formed thereon.

In the single crystal substrate with a multilayer film according to this embodiment, the multilayer film having the compressive stress is provided on the one surface of the single crystal substrate. Therefore, in order to release the compressive stress, a stretching force in a planar direction of the single crystal substrate constantly acts on the multilayer film. Consequently, in general, the single crystal substrate with a multilayer film is significantly warped convexly toward the side provided with the multilayer film.

However, in the single crystal substrate with a multilayer film according to this embodiment, of the two regions obtained by bisecting the single crystal substrate in the thickness direction thereof, the heat-denatured layer is provided at least in the region on the side of the surface of the single crystal substrate opposite to the surface having the multilayer film formed thereon. As a result, in the region on the side provided with the multilayer film with respect to the line bisecting the single crystal substrate in the thickness direction thereof, a force that releases the compressive stress in the multilayer film (stretching force in the planar direction of the single crystal substrate) is canceled out by the stretching force in the planar direction of the single crystal substrate that is caused by the heat-denatured layer in the region on the side of the surface of the single crystal substrate opposite to the surface having the multilayer film formed thereon. As the result, the warpage resulting from the formation of the multilayer film is corrected. In this case, it is basically desirable that the single crystal substrate become as flat as possible through the correction of the warpage, but it is sufficient that the degree of the warpage is slightly reduced while the direction of the warpage resulting from the formation of the multilayer film remains unchanged. Alternatively, the warpage resulting from the formation of the multilayer film may be corrected so that the direction of the warpage resulting from the formation of the multilayer film is reversed and the single crystal substrate is warped in the opposite direction. Note that, in a case where the single crystal substrate becomes substantially flat through the correction of the warpage resulting from the formation of the multilayer film, when the element is produced by performing the subsequent step by using the single crystal substrate with a multilayer film according to this embodiment, it becomes easier to suppress variations in quality or improve the yield of the element than in a case where the conventional single crystal substrate with a multilayer film is used.

Note that, the "heat-denatured layer" refers to a layer formed by locally heating a partial region of the single crystal substrate. When the heat-denatured layer is formed in one of the two regions divided by the line bisecting the single crystal substrate in the thickness direction thereof, the heat-denatured layer has the action of warping the single crystal substrate convexly toward the side of the one of the two regions. It is inferred from this that the heat-denatured layer also has the compressive stress similarly to the multilayer film.

A formation method for the heat-denatured layer is not particularly limited, but usually, there is used a method in which the single crystal substrate is irradiated with a laser. In this case, by multiphoton absorption of atoms present in a region irradiated with the laser, the region is locally heated and some sort of denaturalization such as a change in crystal structure or crystallinity with respect to that in the surrounding region occurs. Accordingly, the heat-denatured layer is formed. That is, the single crystal substrate with a multilayer film according to this embodiment can be manufactured by performing at least a heat-denatured layer formation step after multilayer film formation in which, of the two regions obtained by bisecting, in the thickness direction of the single crystal substrate, the single crystal substrate having the one surface on which the multilayer film having the two or more layers and having the compressive stress is formed, the heat-denatured layer is formed at least in the region on the side of the surface of the single crystal substrate opposite to the one surface having the multilayer film formed thereon by irradiating the laser from the side of the surface of the single crystal substrate opposite to the one surface having the multilayer film formed thereon.

### -Laser Irradiation Condition-

Note that, the irradiation of the laser may be performed under any irradiation condition as long as the heat-denatured layer can be formed. However, in general, it is preferred to use a pulsed laser that intermittently emits laser light because the pulsed laser can concentrate energy in a short time width and hence can obtain a high peak output. Thus, the irradiation of the pulsed laser is preferably performed in ranges 1) and 2) described below.
1) laser wavelength: 200 nm to 5,000 nm
2) pulse width: the order of femtoseconds to the order of nanoseconds (1 fs to 1,000 ns)

Herein, the laser wavelength and the pulse width are appropriately selected in consideration of the light transmittance/light absorption performance resulting from the material of the single crystal substrate as the target of the laser irradiation, the size and pattern precision of the heat-denatured layer formed in the single crystal substrate, and a practically usable laser apparatus. However, in the laser irradiation, it is especially preferable to select Irradiation Condition A or B described below.

### <Irradiation Condition A>

·laser wavelength: 200 nm to 350 nm
·pulse width: the order of nanoseconds (1 ns to 1,000 ns).
Note that, more preferably, 10 ns to 15 ns.

### <Irradiation Condition B>

·laser wavelength: 350 nm to 2,000 nm
·pulse width: the order of femtoseconds to the order of picoseconds (1 fs to 1,000 ps). Note that, more preferably, 200 fs to 800 fs.

Note that, in Irradiation Condition A, the laser having the wavelength shorter than that in Irradiation Condition B is used. As a result, when the laser irradiation is performed under the same conditions except for the laser wavelength and the pulse width, Irradiation Condition A can reduce a laser process time period required to obtain substantially the same level of the effect of correcting the warpage as compared with Irradiation Condition B. In addition, as the laser wavelength to be used, it is suitable to select a wavelength longer than an absorption edge wavelength of the single crystal substrate as the target of the laser irradiation.

Herein, when the single crystal substrate is a sapphire substrate, Irradiation Condition A or B described above can be used. In this case, conditions other than the laser wavelength and the pulse width are preferably selected in ranges described below from the viewpoint of, for example, practicality and mass productivity.
·pulse rate: 50 kHz to 500 kHz
·laser power: 0.05 W to 0.8 W
·laser spot size: 0.5 µm to 4.0 µm (more preferably, approximately 2 µm)
·scanning speed of sample stage: 100 mm/s to 1,000 mm/s

Further, when the single crystal substrate is an Si substrate, Irradiation Condition B described above can be used. In this case, conditions other than the laser wavelength are preferably selected in ranges described below from the viewpoint of, for example, practicality and mass productivity.
·pulse width: 50 ns to 200 ns
·pulse rate: 10 kHz to 500 kHz
·irradiation energy: 3 µJ to 12 µJ
·laser spot size: 0.5 µm to 4.0 µm
·scanning speed of sample stage: 50 mm/s to 1, 000 mm/s (morepreferably 100 mm/s to 1,000 mm/s)

Further, when the single crystal substrate is a GaAs substrate, Irradiation Condition B described above can be used. In this case, conditions other than the laser wavelength are preferably selected in ranges described below from the viewpoint of, for example, practicality and mass productivity.
·pulse width: 30 ns to 80 ns
·pulse rate: 10 kHz to 500 kHz
·irradiation energy: 8 µJ to 20 µJ
·laser spot size: 0.5 µm to 4.0 µm
·scanning speed of sample stage: 50 mm/s to 1, 000 mm/s (morepreferably 100 mm/s to 1,000 mm/s)

Further, when the single crystal substrate is a crystal substrate, Irradiation Condition B described above can be used. In this case, conditions other than the laser wavelength are preferably selected in ranges described below from the viewpoint of, for example, practicality and mass productivity.
·pulse width: 200 fs to 800 fs
·pulse rate: 10 kHz to 500 kHz
·irradiation energy: 3 µJ to 6 µJ
·laser spot size: 0.5 µm to 4.0 µm
·scanning speed of sample stage: 50 mm/s to 1, 000 mm/s (morepreferably 100 mm/s to 1,000 mm/s)

Note that, Table 1 shows an example of laser irradiation conditions when the heat-denatured layer is formed in each of an Si substrate, a GaAs substrate, and a crystal substrate. When the laser irradiation is performed, the surface of the single crystal substrate on the side to be irradiated with the laser is especially preferably in the state of a mirror plane (surface roughness Ra of approximately 1 nm or less). In order to bring the surface to be irradiated with the laser into the state of the mirror plane, for example, mirror polishing can be performed.

**[Table 1]**

| | Si | GaAs | Crystal |
|---|---|---|---|
| Wavelength | 1,064 nm | 1,064 nm | 1,045 nm |
| Pulse width | 120 ns | 70 ns | 500 fs |
| Pulse rate | 100 kHz | 15 kHz | 100 kHz |
| Spot size | 1.5 µm | 1.5 µm | 1.0 µm |
| Laser power | 0.3 W to 1.2 W | 0.2 W | 0.4 W |
| Stage scanning speed | 200 mm/s to 300 mm/s | 200 mm/s | 400 mm/s |

### -Specific example of heat-denatured layer formation step after multilayer film formation-

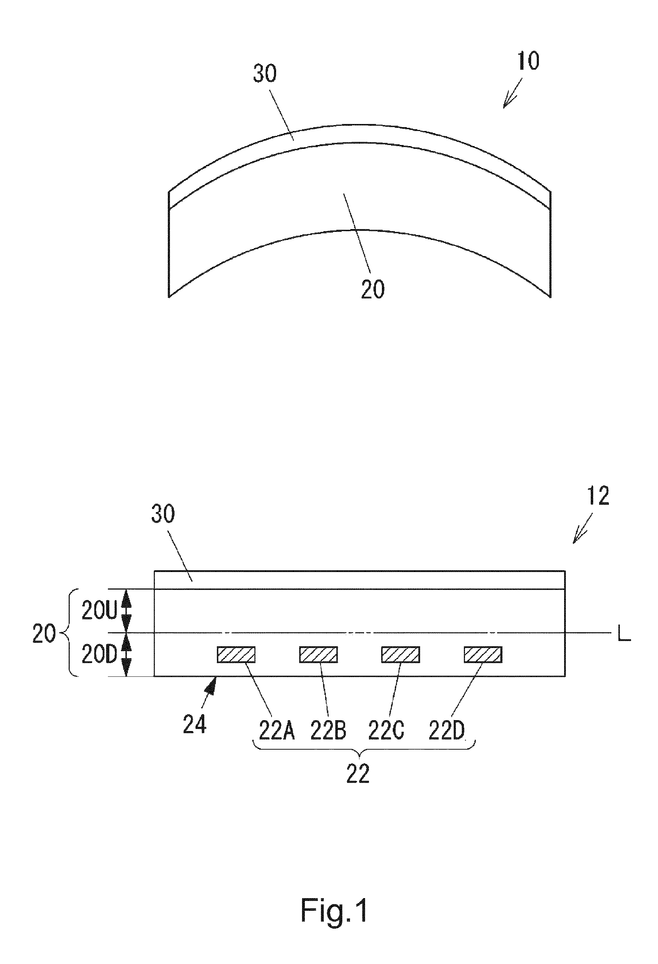

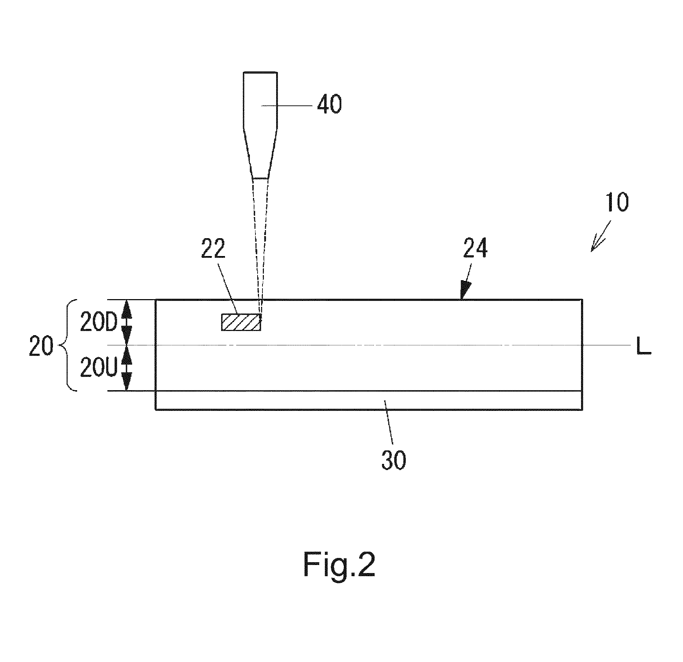

Next, a specific example of the heat-denatured layer formation step after multilayer film formation is described with reference to the drawings. Each of FIGS. 1 and 2 is a schematic explanatory diagram illustrating an example of a manufacturing method for a single crystal substrate with a multilayer film according to this embodiment. Specifically, each of FIGS. 1 and 2 is a schematic explanatory diagram illustrating an example of the heat-denatured layer formation step after multilayer film formation. FIG. 1 is a schematic cross-sectional view illustrating the states of warpage of the single crystal substrate with a multilayer film before and after the heat-denatured layer formation step after multilayer film formation is performed. The upper part of FIG. 1 illustrates the single crystal substrate with a multilayer film before the heat-denatured layer formation step after multilayer film formation is performed, while the lower part of FIG. 1 illustrates the single crystal substrate with a multilayer film after the heat-denatured layer formation step after multilayer film formation is performed. In addition, FIG. 2 is a schematic cross-sectional view illustrating a state during the heat-denatured layer formation step after multilayer film formation, that is, a state in which a laser is irradiated from the side of the surface of the single crystal substrate on which the multilayer film is not formed. Note that, the individual layers constituting the multilayer film are omitted in each of FIGS. 1 and 2.

As illustrated in the upper part of FIG. 1, a single crystal substrate with a multilayer film (substrate with a film before laser processing) 10 before the heat-denatured layer formation step after multilayer film formation is performed includes a single crystal substrate 20 and a multilayer film 30 formed on one surface of the single crystal substrate 20. In addition, the substrate with a film before laser processing 10 is warped convexly toward the side of the surface provided with the multilayer film 30. In contrast to this, in a single crystal substrate with a multilayer film (substrate with a film after laser processing 12) after the heat-denatured layer formation step after multilayer film formation illustrated in the lower part of FIG. 1 is performed, the warpage illustrated in the upper part of FIG. 1 is corrected, and the single crystal substrate with a multilayer film is made substantially flatter. Of two regions 20U and 20D obtained by bisecting the single crystal substrate 20 along a one-dot chain line L in the thickness direction thereof, at least in the region (non-film formation surface side region) 20D on the side of the surface of the single crystal substrate 20 opposite to the surface having the multilayer film 30 formed thereon, a plurality of heat-denatured layers 22 each having a predetermined thickness are formed at regular intervals in the planar direction of the single crystal substrate 20.

Herein, as one example is illustrated in FIG. 2, the heat-denatured layer formation step after multilayer film formation is performed in a state in which the substrate with a film before laser processing 10 is fixed to a sample stage (not shown) so that the surface provided with the multilayer film 30 is positioned to be the lower surface side. Note that, the fixing is preferably performed so that the warpage of the substrate with a film before laser processing 10 can be corrected through, for example, vacuum suction or the like. When the vacuum suction cannot be performed due to extremely large warpage, it is possible to monitor the shape of the surface of the substrate with a film before laser processing 10 to set a laser irradiation region in parallel to the surface of the substrate with a film before laser processing 10. Subsequently, from the side of a surface (non-film formation surface) 24 of the substrate with a film before laser processing 10, which is fixed to the sample stage, opposite to the surface provided with the multilayer film, the laser is irradiated by a laser irradiation apparatus 40. At this time, the laser is concentrated onto the internal portion of the non-film formation surface side region 20D of the single crystal substrate 20, and the laser irradiation apparatus 40 and the substrate with a film before laser processing 10 are moved relative to each other in the horizontal direction. In this manner, the heat-denatured layer 22 is formed. Here, through appropriate selection of the spot size, laser power, and pulse width of the laser, it is possible to control the degree of denaturalization and the size of the heat-denatured layer 22 in the planar direction and the thickness direction of the single crystal substrate 20. In addition, through appropriate selection of the movement speed of the laser irradiation apparatus 40 relative to the substrate with a film before laser processing 10 (for example, when the sample stage is movable, the scanning speed of the sample stage) and the pulse rate of the laser, it is possible to control intervals between individual heat-denatured layers 22A, 22B, 22C, and 22D in the planar direction of the single crystal substrate 20.

### -Disposition pattern of heat-denatured layer-

In the single crystal substrate with a multilayer film according to this embodiment, as illustrated in FIG. 1, when the heat-denatured layer 22 is provided at least in the non-film formation surface side region 20D, it is possible to correct the warpage of the single crystal substrate 20 resulting from the compressive stress of the multilayer film 30. However, when the heat-denatured layer 22 is provided at a deviated position, irregularly disposed, or asymmetrically disposed in the thickness direction or the planar direction of the single crystal substrate 20, there are cases where it becomes difficult to correct the warpage occurring due to the multilayer film 30, or the shape of the substrate with a film after laser processing 12 is distorted.

In order to avoid the occurrence of the above-mentioned problem, in the thickness direction of the single crystal substrate 20, the heat-denatured layer 22 is preferably provided in parallel to the multilayer film 30. In this case, when the relative position of the heat-denatured layer 22 in the thickness direction of the single crystal substrate 20 is assumed to be 0% at the surface provided with the multilayer film 30 and 100% at the surface (non-filmformation surface 24) opposite to the surface provided with the multilayer film 30, the heat-denatured layer 22 is preferably provided in a range of more than 50% and 95% or less in the thickness direction of the single crystal substrate 20, and more preferably in a range of 70% or more and 95% or less. With provision of the heat-denatured layer 22 in the ranges of values described above in the thickness direction of the single crystal substrate 20, it is possible to more effectively correct the warpage of the single crystal substrate 20 resulting from the compressive stress of the multilayer film 30 and also suppress the deformation of the substrate with a film after laser processing 12. Note that, regarding the position of presence of the heat-denatured layer 22 in the thickness direction of the single crystal substrate 20, the individual heat-denatured layers 22A, 22B, 22C, and 22D are preferably present all at the same position, but the individual heat-denatured layers may also be present at different positions. In this case, the individual heat-denatured layers 22A, 22B, 22C, and 22D may be disposed at different positions in the thickness direction of the single crystal substrate 20 so that, also in view of the disposition positions of the individual heat-denatured layers 22A, 22B, 22C, and 22D in the planar direction of the single crystal substrate 20, the shape of the substrate with a film after laser processing 12 is not distorted or the effect of correcting the warpage resulting from providing the heat-denatured layer 22 is not significantly reduced. In addition, the length of the heat-denatured layer 22 in the thickness direction of the single crystal substrate 20 is determined depending on the spot size, the irradiation energy (laser power/pulse rate), and the pulse width of the laser, and is usually in a range of several micrometers to several tens of micrometers.

In addition, in order to avoid the occurrence of the above-mentioned problem, in the planar direction of the single crystal substrate 20, the heat-denatured layer 22 is preferably provided to have the following pattern shapes. That is, in the planar direction of the single crystal substrate 20, the heat-denatured layer 22 is preferably provided to have at least one pattern shape selected from the following shapes i) to vii). In this case, it is possible to more effectively correct the warpage of the single crystal substrate 20 resulting from the compressive stress of the multilayer film 30 and also suppress the deformation of the single crystal substrate 20.
i) a shape in which a plurality of polygons identical in shape and size are regularly disposed;
ii) a shape inwhichapluralityof circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

Note that, among the pattern shapes i) to vii) described above, from the viewpoint that it is possible to more uniformly correct the warpage of the single crystal substrate 20 resulting from the compressive stress of the multilayer film 30 and further reduce the distortion of the shape, the pattern shapes i) to iv) are more preferable.

In addition, when the heat-denatured layer 22 is formed, from the viewpoint that laser scanning, that is, the movement of the laser irradiation apparatus 40 relative to the substrate with a film before laser processing 10 is relatively simple as compared with other pattern shapes so as to facilitate the laser process, the pattern shape is preferably i) the shape in which the plurality of polygons identical in shape and size are regularly disposed. Further, as i) the shape in which the plurality of polygons identical in shape and size are regularly disposed, a shape in which a plurality of quadrangles identical in shape and size are regularly disposed so that four sides constituting each quadrangle coincide with any one of four sides of an adjacent quadrangle, that is, a lattice shape is especially preferable. In this case, it is only necessary to perform the laser scanning in vertical and lateral directions. Thus, the laser process can be further facilitated, and the designing of the warpage amount control and the shape control of the substrate with a film after laser processing 12 can also be further facilitated.

Herein, the pitch between the lines constituting the pattern forming the lattice shape is preferably in a range of 50 µm to 2,000 µm, and more preferably in a range of 100 µm to 1,000 µm. With the setting of the pitch to 50 µm or more, it is possible to suppress an unnecessary increase in time period required for the laser process and, with the setting of the pitch to 2,000 µm or less, it is possible to more reliably correct the warpage of the single crystal substrate 20 resulting from the compressive stress of the multilayer film 30.

FIGS. 3 are plan views illustrating examples of the disposition pattern shape of the heat-denatured layer in the planar direction of the single crystal substrate 20. Specifically, FIGS. 3 illustrate examples of the disposition pattern shape of the heat-denatured layer 22 when the planar shape of the single crystal substrate 20 is the circular shape having the orientation flat plane. As illustrated in FIGS. 3, examples of the disposition pattern shape of the heat-denatured layer 22 include stripe shapes (FIGS. 3A and 3B) in which a plurality of lines are formed perpendicular to or in parallel to the orientation flat plane of the substrate, and a lattice shape (FIG. 3C) obtained by combining the above-mentioned stripe shapes. In addition, other examples of the disposition pattern shape include a shape (FIG. 3D) in which a plurality of regular hexagons identical in size are regularly disposed so that each of six vertices of each regular hexagon always coincides with any one of vertices of an adjacent regular hexagon, and a concentric shape (FIG. 3E). Note that, a width W illustrated in FIG. 3A denotes the pitch between lines.

Note that, the degree of the warpage resulting from the compressive stress of the multilayer film 30 varies depending on the compressive stress determined by the layer structure and the film thickness of the multilayer film 30 and the rigidity of the single crystal substrate 20 determined by the thickness and the material thereof. However, in accordance with the degree of the warpage, through appropriate selection and combination of the above-mentioned i) length of the heat-denatured layer 22 in the thickness direction of the single crystal substrate 20, ii) disposition position of the heat-denatured layer 22 in the thickness direction of the single crystal substrate 20, and iii) disposition pattern shape of the heat-denatured layer 22 in the planar direction of the single crystal substrate 20, regarding the substrate with a film before laser processing 10, it is possible to not only correct the warpage resulting from the multilayer film 30 in the substrate with a film after laser processing 12, but also form the substrate with a film after laser processing 12 into a substantially flat shape.

### -Formation of heat-denatured layer before formation of multilayer film-

In the manufacturing method for a single crystal substrate with a multilayer film according to this embodiment, basically through formation of the heat-denatured layer 22 in the internal portion of the single crystal substrate 20 by laser irradiation after the formation of the multilayer film 30, the warpage of the substrate 12 resulting from the formation of the multilayer film 30 is corrected. Consequently, it is possible to suppress adverse effects such as variations in quality and a reduction in yield resulting from the warpage when the subsequent step is performed by using the substrate with a film after laser processing 12. Therefore, even when the single crystal substrate 20 is warped in any manner during the film formation process of the multilayer film 30, an adverse effect on the subsequent step is extremely small. This produces, in relation to the subsequent step, the first merit that i) it is possible to increase the degree of freedom in the film formation process of the multilayer film 30, that is, options for the film formation method and film formation condition that can be adopted, and the second merit that ii) the layer structure of the multilayer film 30 can be selected without consideration of the occurrence of the warpage or the size of the warpage after the formation of the multilayer film 30.

The single crystal substrate with a multilayer film according to this embodiment can be manufactured by performing, in the following order, at least: (1) a heat-denatured layer formation step before multilayer film formation in which, by irradiating the laser from the side of the one surface of the single crystal substrate, when the relative position of a heat-denatured layer in the thickness direction of the single crystal substrate is assumed to be 0% at the one surface on the side from which the laser is irradiated and 100% at the surface opposite to the one surface on the side from which the laser is irradiated, the heat-denatured layer is formed so as to be positioned in a range of 0% or more and less than 50% in the thickness direction of the single crystal substrate; (2) a multilayer film formation step in which the multilayer film including the two or more layers and having the compressive stress is formed on the surface of the single crystal substrate on the side from which the laser is irradiated, the single crystal substrate having the heat-denatured layer formed therein; and (3) the heat-denatured layer formation step after multilayer film formation. Note that, in the following description, the heat-denatured layer formed by the heat-denatured layer formation step before multilayer film formation is sometimes referred to as a "second heat-denatured layer", while the heat-denatured layer formed by the heat-denatured layer formation step after multilayer film formation is sometimes referred to as a "first heat-denatured layer".

Asdescribed above,beforethe multilayerfilmformation step is performed, the heat-denatured layer formation step before multilayer film formation, in which the second heat-denatured layer is formed in the internal portion of the single crystal substrate in advance, is performed. Note that, the second heat-denatured layer formed in the heat-denatured layer formation step before multilayer film formation needs to be formed so as to be positioned in the range of 0% or more and less than 50% in the thickness direction of the single crystal substrate. This is because, when the second heat-denatured layer is formed outside the range described above, a region where the first heat-denatured layer formed in the heat-denatured layer formation step after multilayer film formation is to be formed is limited in the thickness direction of the single crystal substrate, and hence the correction of the warpage of the single crystal substrate 20 after the formation of the multilayer film 30 sometimes becomes difficult.

As described above, the second heat-denatured layer formed in the heat-denatured layer formation step before multilayer film formation needs to be formed so as to be positioned in the range of 0% or more and less than 50% in the thickness direction of the single crystal substrate, and the lower limit value thereof is preferably 3% or more. When the second heat-denatured layer is formed in the vicinity of 0% in the thickness direction of the single crystal substrate, that is, in the vicinity of the film formation surface on which the multilayer film is formed, the crystal plane exposed on the film formation surface becomes likely to change. As a result, in particular, when, among the individual layers constituting the multilayer film 30, a layer (lowermost layer) that is held in direct contact with the film formation surface is a crystalline film, the lowermost layer is affected by the change in the crystal plane exposed on the film formation surface. Thus, the crystal structure or the crystallinity of the lowermost layer becomes likely to change. In addition, also when other crystalline layers are successively laminated on the lowermost layer, those other crystalline layers are affected by the crystal structure or the crystallinity of the lowermost layer serving as the base, and thus become likely to change. Therefore, when the lowermost layer is to be crystal-grown by utilizing the original crystal plane of the film formation surface of the single crystal substrate, the crystal growth is inhibited. However, when the lower limit value is set to 3% or more, it is possible to suppress the change in the crystal plane exposed on the film formation surface caused by the formation of the secondheat-denatured layer, and hence it is possible to avoid the occurrence of the above-mentioned problem. Note that, the second heat-denatured layer is more preferably formed so as to be positioned in the range of 5% or more and 30% or less in the thickness direction of the single crystal substrate.

In addition, the second heat-denatured layer is provided on the side provided with the multilayer film with respect to the line bisecting the single crystal substrate in the thickness direction thereof, and hence the second heat-denatured layer functions similarly to the multilayer film in terms of the occurrence of the warpage of the single crystal substrate. That is, the second heat-denatured layer facilitates warpage convex toward the side provided with the multilayer film of the single crystal substrate immediately after the formation of the multilayer film. For example, assume a case in which, in the thickness direction of the single crystal substrate, the first and second heat-denatured layers are provided at positions linearly-symmetric with respect to the line bisecting the single crystal substrate, the lengths of the first and second heat-denatured layers in the thickness direction of the single crystal substrate are the same, and the disposition pattern shapes of the first and second heat-denatured layers in the planar direction of the single crystal substrate are similar. In this case, the warpage direction and the warpage amount of the single crystal substrate simply depend on a difference in total area between the two heat-denatured layers, and hence it is only necessary to form the second heat-denatured layer in the internal portion of the single crystal substrate so that the total area of the second heat-denatured layer in the planar direction of the single crystal substrate is smaller than that of the first heat-denatured layer.

Note that, except for the above-mentioned points, it is possible to appropriately select the laser irradiation conditions and the laser processing method when the second heat-denatured layer is formed and the disposition pattern shape of the second heat-denatured layer in the planar direction of the single crystal substrate, as in the case of the first heat-denatured layer.

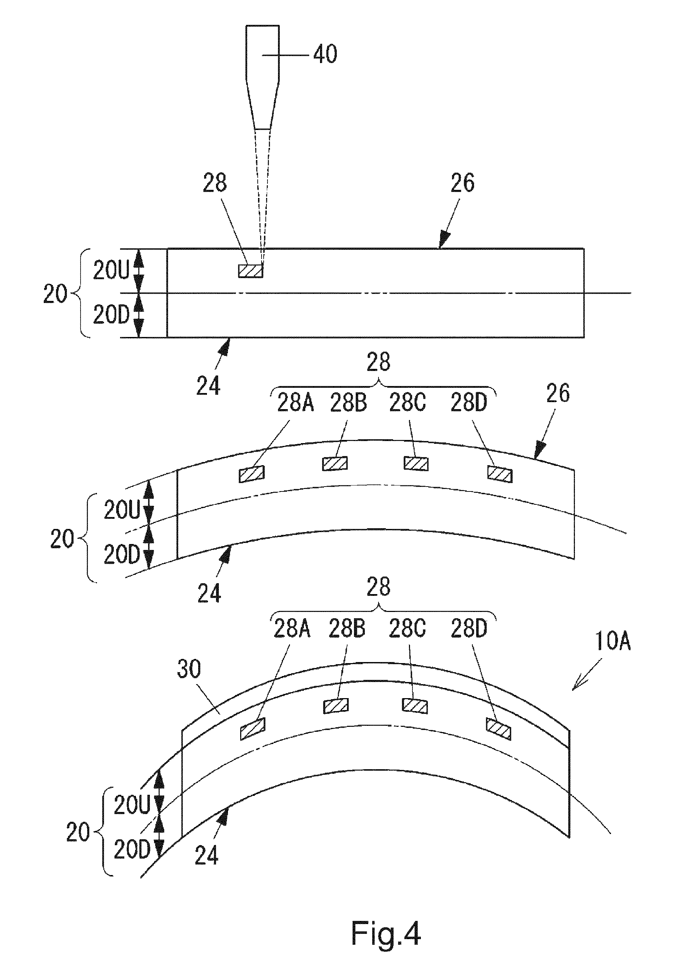

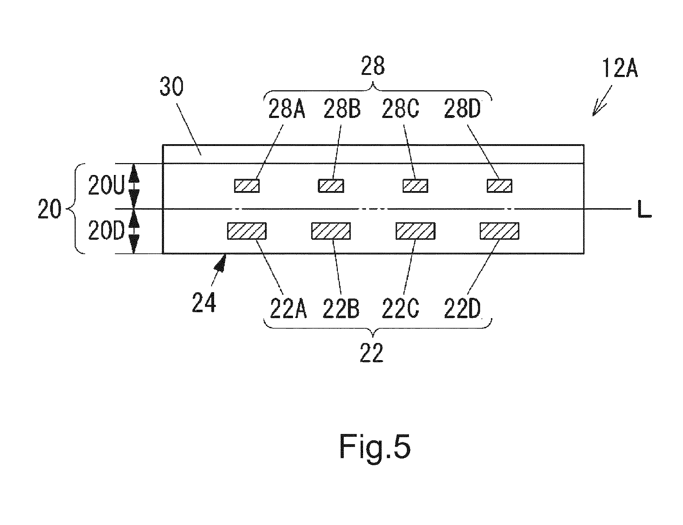

FIG. 4 is a schematic explanatory diagram illustrating another example of the manufacturing method for a single crystal substrate with a multilayer film according to this embodiment. Specifically, FIG. 4 is a diagram illustrating a case where the single crystal substrate with a multilayer film is produced by performing, on the single crystal substrate that is not subjected to any laser processing or film formation process, the heat-denatured layer formation step before multilayer film formation, the multilayer film formation step, and the heat-denatured layer formation step after multilayer film formation in the stated order. In addition, FIG. 5 is a schematic cross-sectional view illustrating another example of the single crystal substrate with a multilayer film according to this embodiment. Specifically, FIG. 5 is a view illustrating an example of a cross-sectional structure of the single crystal substrate with a multilayer film obtained by performing the production process illustrated in FIG. 2 after performing the production process illustrated in FIG. 4. Herein, in FIGS. 4 and 5, components having the same functions and structures as those illustrated in FIGS. 1 and 2 are represented by the same reference symbols.

Herein, as illustrated in the upper part of FIG. 4, the heat-denatured layer formation step before multilayerfilmformation is performed in a state in which the substantially flat single crystal substrate 20 that is not subjected to any laser processing or film formation process is fixed to a sample stage (not shown) so that the non-film formation surface 24 is positioned to be the lower surface side. Subsequently, to the single crystal substrate 20 fixed to the sample stage, the laser is irradiated by the laser irradiation apparatus 40 from the side of the surface (film formation surface 26) opposite to the non-film formation surface 24. At this time, the laser is concentrated onto a portion in the region (film formation surface side region 20U) opposite to the non-film formation surface side region 20D with respect to the line indicated by the one-dot chain line of FIG. 4 that bisects the single crystal substrate 20 in the thickness direction thereof, and the laser irradiation apparatus 40 and the single crystal substrate 20 are moved relative to each other in the horizontal direction. With this, as illustrated in the middle part of FIG. 4, a second heat-denatured layer 28 is formed in the film formation surface side region 20U of the single crystal substrate 20. Note that, due to the formation of the second heat-denatured layer 28 in the film formation surface side region 20U, the single crystal substrate 20 that has been subjected to the heat-denatured layer formation step before multilayer film formation is slightly warped convexly toward the side of the film formation surface 26 as compared with the single crystal substrate 20 before the heat-denatured layer formation step before multilayer film formation is performed. Here, through appropriate selection of the spot size, laser power, and pulse width of the laser, it is possible to control the degree of denaturalization and the size of the second heat-denatured layer 28 in the planar direction and the thickness direction of the single crystal substrate 20. In addition, through appropriate selection of the movement speed of the laser irradiation apparatus 40 relative to the single crystal substrate 20 (for example, when the sample stage is movable, the scanning speed of the sample stage) and the pulse rate of the laser, it is possible to control intervals between individual second heat-denatured layers 28A, 28B, 28C, and 28D in the planar direction of the single crystal substrate 20.

Next, the multilayer film formation step, in which the multilayer film 30 is formed on the film formation surface 26 of the single crystal substrate 20 having the second heat-denatured layer 28 formed therein, is performed. With this, as illustrated in the lower part of FIG. 4, it is possible to obtain a substrate with a film before the second laser processing 10A in which the multilayer film 30 is formed on the film formation surface 26 of the single crystal substrate 20 having the second heat-denatured layer 28 formed therein. At the time of performing the multilayer film formation step, the formation of the second heat-denatured layer 28 enables the warpage of the single crystal substrate 20 to be set to 0 in any process of the warpage behavior of the single crystal substrate 20 during the multilayer film formation step. Note that, the substrate with a filmbefore the second laser processing 10A is warped convexly toward the side of the film formation surface 26 by the influence of the compressive stress of the multilayer film 30.

After the multilayer film formation step, in the same manner as that illustrated in FIG. 2 except that the substrate with a film before the second laser processing 10A is used instead of the substrate with a film before laser processing 10, the heat-denatured layer formation step before multilayerfilmformation is performed. With this, the first heat-denatured layer 22 is further formed in the non-film formation surface side region 20D of the single crystal substrate 20, and, as illustrated in FIG. 5, it is possible to obtain a single crystal substrate with the multilayer film 30 (substrate with a film after the second laser processing 12A) in which the first heat-denatured layer 22 and the second heat-denatured layer 28 are formed in the internal portion of the single crystal substrate 20. In the substrate with a film after the second laser processing 12A, with the first heat-denatured layer 22 formed in the non-film formation surface side region 20D of the single crystal substrate 20, a convexly warping force toward the side of the film formation surface 26 by the influence of the compressive stress of the multilayer film 30 is canceled out. Note that, in the example illustrated in FIG. 5, the first heat-denatured layer 22 and the second heat-denatured layer 28 identical in length in the thickness direction of the single crystal substrate 20 are provided at positions linearly-symmetric in the thickness direction of the single crystal substrate 20 with respect to a line L bisecting the single crystal substrate 20 in the thickness direction thereof. In addition, the disposition patterns of the first heat-denatured layer 22 and the secondheat-denatured layer 28 in the planar direction of the single crystal substrate 20 are identical with each other, but the total area of the first heat-denatured layer 22 in the planar direction of the single crystal substrate 20 is set to be larger than the total area of the second heat-denatured layer 28.

### -Single crystal substrate-

As the material constituting the single crystal substrate 20 used in the production of the single crystal substrate with a multilayer film according to this embodiment, there can be used any known single crystal material capable of forming the heat-denatured layers 22 and 28 by laser irradiation, and examples of the material include sapphire, nitride semiconductor, Si, GaAs, crystal, and SiC. Note that, the single crystal substrate with a multilayer film according to this embodiment uses a substrate made of a single crystal material. However, even when a substrate made of a polycrystalline material (for example, a quartz substrate) or a substrate made of a non-crystalline material (for example, a glass substrate) is used instead of the above-mentioned substrate, it is also possible to obtain a flat substrate with a multilayer film in which the occurrence of the warpage resulting from the multilayer film is corrected.

In addition, as the single crystal substrate 20, usually, the single crystal substrate having at least one mirror-polished surface is used. In this case, the multilayer film 30 is formed on the side of the mirror-polished surface. Note that, the single crystal substrate 20 having both surfaces subjected to mirror-polishing may also be used as needed. In this case, one of the surfaces can be arbitrarily used as the film formation surface 26. Further, as the single crystal substrate 20 used in the production of the single crystal substrate with a multilayer film according to this embodiment, from the viewpoint of ease of production and availability of a substrate, there is used a substrate in which any heat-denatured layer by the laser processing or any composition denatured layer by ion implantation is not formed, and which usually has the warpage amount of approximately 0 in a state in which no film is formed, that is, is substantially flat.

The shape of the single crystal substrate 20 in the planar direction is not particularly limited, and the shape thereof may be, for example, a square or the like. However, from the viewpoint of ease of application to the production lines for various known elements, a circular shape is preferable, and a circular shape provided with an orientation flat plane is especially preferable.

When the shape of the single crystal substrate 20 is the circular shape or the circular shape provided with the orientation flat plane, the diameter of the single crystal substrate 20 is preferably 50 mm or more, more preferably 75 mm or more, and further more preferably 100 mm or more. In a case where the diameter is set to 50 mm or more, when the single crystal substrate 20 is warped during or after the formation of the multilayer film 30, the increase in diameter leads to the increase in difference in height (warpage amount) between the vicinity of the central portion of the single crystal substrate 20 and the vicinity of the end portion thereof in the vertical direction when the single crystal substrate 20 is assumed to be placed on a flat surface. However, when the first heat-denatured layer 22 is formed after the formation of the multilayer film 30, it is possible to correct such large warpage to easily reduce the warpage amount, and hence it is possible to reduce an adverse effect on the subsequent step. In addition to the first heat-denatured layer 22, the second heat-denatured layer 28 is formed before the formation of the multilayer film 30. In addition, because of the above-mentioned reason, in a case where the single crystal substrate with a multilayer film according to this embodiment is manufactured, as compared with the conventional case, as the diameter of the single crystal substrate 20 becomes larger, it is possible to more effectively suppress the warpage after the formation of the multilayer film 30. Note that, the upper limit value of the diameter is not particularly limited but, from the viewpoint of practicality, is preferably 300 mm or less.

Further, the thickness of the single crystal substrate 20 is preferably 5.0 mm or less, preferably 3.0 mm or less, and more preferably 2.0 mm or less. In a case where the thickness thereof is set to 5.0 mm or less, the thickness is small, and hence the rigidity of the single crystal substrate 20 is reduced and the single crystal substrate 20 becomes likely to be deformed. In this case, after the formation of the multilayer film 30, the warpage amount of the single crystal substrate 20 becomes likely to be increased. However, when the first heat-denatured layer 22 is formed after the formation of the multilayer film 30, it is possible to correct such large warpage to easily reduce the warpage amount, and hence it is possible to reduce an adverse effect on the subsequent step. Further, because of the circumstances described above, when it is necessary to polish the single crystal substrate 20 to a predetermined thickness by polishing on the side of the non-film formation surface 24 in the subsequent step, it is possible to form the multilayer film 30 by using the single crystal substrate 20 having a smaller thickness so that a polishing allowance is further reduced in such a range that the adverse effect on the subsequent step is not increased. In this case, it is possible to reduce a time period required for polishing in the subsequent step to improve productivity in the subsequent step.

The lower limit value of the thickness is not particularly limited but, from the viewpoint of securing a region where the heat-denatured layers 22 and 28 can be formed, the lower limit value is preferably 0.05 mm or more and preferably 0.1 mm or more. In a case where the shape of the single crystal substrate 20 is the circular shape or the circular shape provided with the orientation flat plane, when the diameter is 50 mm or more and 100 mm or less, the thickness is preferably 0.3 mm or more, and when the diameter is more than 100 mm, the thickness is preferably 0.5 mm or more.

### -Multilayer film-

In the description of the present application, the "multilayer film" refers to a film that includes two or more layers and has the compressive stress before the formation of the heat-denatured layer (that is, before the heat-denatured layer formation step after multilayer film formation). In addition to this, the "multilayer film" means a film in which each layer constituting the multilayer film is formed of consecutive layers identical in film thickness in the planar direction of the substrate and which does not have a stepped portion extending through a film of the outermost layer. The layer structure of the multilayer film 30, and the film thickness, the material, and the crystallinity/non-crystallinity of each layer constituting the multilayer film 30 are appropriately selected depending on the type of an element to be produced by using the single crystal substrate with a multilayer film according to this embodiment and further performing a subsequent step thereon, and the production process used when the element is produced.

However, at least one of the layers constituting the multilayer film 30 is preferably a crystalline layer. In addition, from the viewpoint of enabling epitaxial growth by using the crystal plane exposed on the film formation surface 26 of the single crystal substrate 20, among the individual layers constituting the multilayer film 30, at least the layer that is held in direct contact with the film formation surface 26 of the single crystal substrate 20 is preferably a crystalline layer, and all of the layers constituting the multilayer film 30 may also be crystalline layers. Note that, epitaxial growth includes homoepitaxial growth and heteroepitaxial growth that include the same composition or a mixed crystal. Further, the material of each layer constituting the multilayer film 30 is also appropriately selected depending on the element to be produced. However, in consideration that the single crystal substrate 20 is made of an inorganic material such as a sapphire substrate, the material constituting each layer is preferably an inorganic material such as a metal material, a metal oxide material, and an inorganic semiconductor material, and all layers are desirably made of those inorganic materials. However, when an MOCVD method is used as the film formation method, there are cases where an organic matter of an organic metal origin is contained in the inorganic material of the layer.

Specific examples of each layer constituting the multilayer film 30 may include, as the layer suitable for the production of elements using various types of nitride semiconductor such as a light emitting element to be used in a surface emitting laser or the like, a light receiving element to be used in an optical sensor or a solar cell, and a semiconductor element to be used in an electronic circuit or the like, GaN-based, AlGaN-based, and InGaN-based nitride semiconductor crystal layers. In this case, as the single crystal substrate 20, it is suitable to use the sapphire substrate. In addition, as a specific example of the layer structure of the multilayer film 30, for example, in a case where a light emitting element using the nitride semiconductor is produced as the element, the sapphire substrate can be used as the single crystal substrate 20, and there can be adopted a layer structure in which, from the side of the sapphire substrate, (1) a buffer layer made of GaN, an n-type contact layer made of n-type GaN, an n-type cladding layer made of n-type AlGaN, an active layer made of n-type InGaN, a p-type cladding layer made of p-type AlGaN, and a p-type contact layer made of p-type GaN are laminated in the stated order.

The film thickness of the multilayer film 30 is appropriately selected depending on the element to be produced. In general, as the film thickness of the multilayer film 30 is increased, the warpage amount of the single crystal substrate 20 after the formation of the multilayer film 30 is also increased. Conventionally, the effect on variations in element quality and the yield of the element becomes marked, and the warpage behavior during the formation of the multilayer film 30 is prone to be larger. In addition, in this case, a crack becomes likely to occur in the multilayer film 30 due to a brittle fracture resulting from the warpage. However, it is possible to reduce the warpage amount by correcting the warpage resulting from the formation of the multilayer film 30 by forming the first heat-denatured layer 22 in the internal portion of the single crystal substrate 20 after the formation of the multilayer film 30. Note that, the upper limit of the film thickness of the multilayer film 30 is not particularly limited. In addition, the number of layers of the multilayer film may be any number equal to or more than two, and the number of layers can appropriately be selected depending on the type of the element to be produced.

The film formation method for the multilayer film 30 is not particularly limited, and it is possible to use known film formation methods. It is also possible to adopt a different film formation method and/or a different film formation condition for each of the layers constituting the multilayer film 30 to form the film. Examples of the film formation method include a liquid phase deposition method such as a plating method, but it is preferable to use a vapor phase deposition method such as a sputtering method or a chemical vapor deposition (CVD) method. When a semiconductor crystal layer such as a nitride semiconductor crystal layer is formed for producing a light emitting element or the like, it is more preferable to use the vapor phase deposition method such as a metal organic chemical vapor deposition (MOCVD) method, a hydride vapor phaseepitaxy (HVPE) method, oramolecularbeamepitaxy (MBE) method. Note that, the surface of the single crystal substrate 20 on which the multilayer film 30 is formed is especially preferably in the state of the mirror plane (surface roughness Ra of approximately 1 nm or less). In order to bring the surface on which the multilayer film 30 is formed into the state of the mirror plane, for example, mirror polishing can be performed.

### -Control of warpage (curvature) of single crystal substrate during formation of multilayer film-

In the manufacturing method for a single crystal substrate with a multilayer film according to this embodiment, through formation of the first heat-denatured layer 22 in the internal portion of the single crystal substrate 20 after the formation of the multilayer film 30, it is possible to correct the warpage of the single crystal substrate 20 that occurs after the formation of the multilayer film 30. Consequently, as compared with the conventional method, in the manufacturing method for a single crystal substrate with a multilayer film according to this embodiment, it is possible to perform the multilayer film formation step without considering the occurrence of the warpage after the end of the formation of the multilayer film 30, and hence there is large flexibility in the film formation process of the multilayer film 30. In this respect, it can be said that, in the multilayer film formation step, the single crystal substrate 20 is allowed to be warped in any manner. However, in the formation of each layer constituting the multilayer film 30, when the single crystal substrate 20 is significantly warped, variations in film thickness or film quality in the surface of the substrate occur. In general, the above-mentioned variations in the surface of the substrate tend to be increased in proportion to the warpage of the single crystal substrate 20. When the above-mentioned variations in the surface of the substrate are increased, this leads to an increase in variations in quality or a reduction in yield of the element obtained by performing the subsequent step on the single crystal substrate with a multilayer film according to this embodiment. In view of the circumstances described above, in the multilayer film formation step, the curvature of the surface of the single crystal substrate 20 on which the multilayer film 30 is formed during the formation of at least one layer among layers constituting the multilayer film 30 is preferably in a range of ±30 km⁻¹, and more preferably in a range of ±20 km⁻¹.

Note that, it is ideal that the curvature ranges described above are satisfied in all layers constituting the multilayer film 30. However, in general, the single crystal substrate 20 exhibits a complicated warpage behavior in the process of the formation of the multilayer film 30, and hence, in practice, it is difficult to satisfy the curvature ranges described above in all layers constituting the multilayer film 30. In view of this point, it is especially preferable that the above-mentioned curvature ranges are satisfied in, among the layers constituting the multilayer film 30, a layer (most important layer) that influences variations in quality or the yield of the element most significantly when the warpage of the single crystal substrate 20 is increased. The most important layer described above varies depending on the type of the element and the structure of the multilayer film 30 in accordance with the type of the element. When the element is a light emitting element using nitride semiconductor, an example of the most important layer includes, as at least one layer among the individual layers constituting the multilayer film 30, a nitride semiconductor crystal layer capable of functioning as a light emitting layer.

A method of controlling the curvature of the surface of the single crystal substrate 20 on which the multilayer film 30 is formed during the formation of at least one layer among the individual layers constituting the multilayer film 30 so that the curvature thereof falls within the above-mentioned ranges is not particularly limited. Examples of the method include 1) a method of changing a film formation method and film formation conditions for each layer constituting the multilayer film 30, 2) a method of changing the size of the single crystal substrate 20, 3) a method of changing the thickness of the single crystal substrate 20, and 4) a method of forming the second heat-denatured layer 28 in the internal portion of the single crystal substrate 20 before the formation of the multilayer film 30. However, in view of mass production of the element, all of the methods 1) to 3) described above significantly influence the performance of the element and the productivity and the yield of the element, and hence it is difficult to make a significant change in many cases in terms of practicality. Consequently, even when the methods 1) to 3) are adopted, there are cases where it becomes difficult to control the curvature within the above-mentioned ranges. In view of the above-mentioned circumstances, as the method of controlling the curvature within the above-mentioned ranges, it is most preferable to adopt 4) the method of forming the second heat-denatured layer 28 in the internal portion of the single crystal substrate 20 before the formation of the multilayer film 30. The reason for this is as follows. That is, in this method, it is possible to easily control the degree of the warpage (curvature) and the rigidity of the single crystal substrate 20 before the formation of the multilayer film 30 in accordance with the film formation process of the multilayer film 30 by appropriately selecting the formation position of the second heat-denatured layer 28 and the size of the formation region thereof in the internal portion of the single crystal substrate 20. Therefore, in this method, it is easy to control the curvature of the single crystal substrate 20 without adversely affecting the performance, the productivity, and the yield of the element.

### -Specific example of multilayer film formation step-

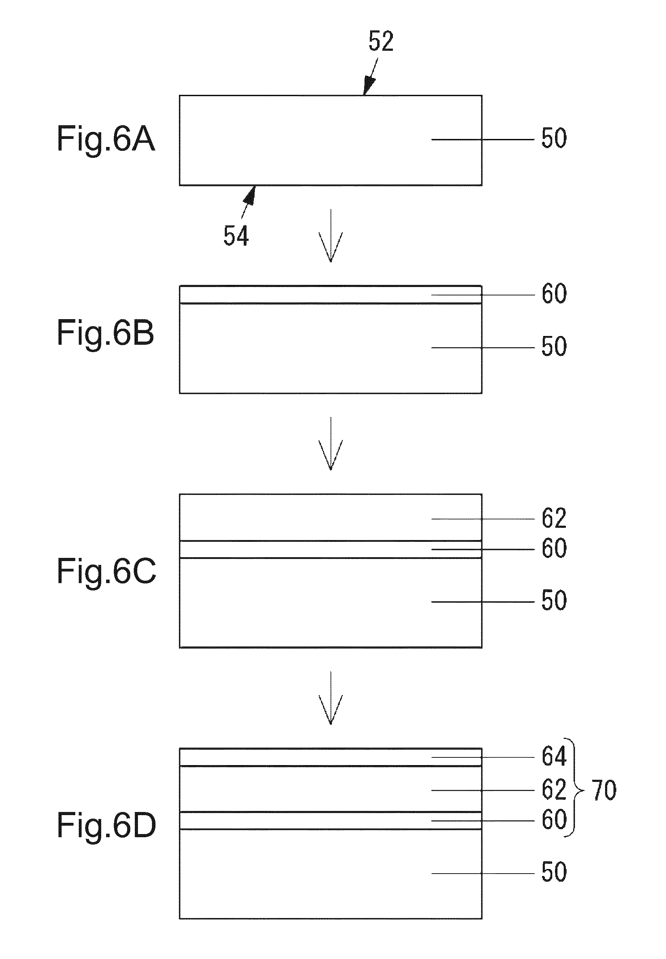

Next, as a specific example of a case where the multilayer film30 is formed, description is made, with reference to the drawings, of a case where a sapphire substrate is used as the single crystal substrate 20, and the multilayer film 30 is formed on one surface of the sapphire substrate by laminating a plurality of nitride semiconductor layers by epitaxial growth. FIGS. 6 are schematic explanatory diagrams illustrating an example of the multilayer film formation step. Specifically, FIGS. 6 are diagrams illustrating the process of forming the multilayer film by laminating a nitride semiconductor layer and the like on the sapphire substrate. FIG. 6A illustrates a state before the film formation is started. FIG. 6B illustrates a state after a low-temperature buffer layer is formed. FIG. 6C illustrates a state after an n-GaN layer is formed. FIG. 6D illustrates a state after an InGaN-based active layer having a multi-quantum well structure is formed. Note that, in FIGS. 6, illustration is omitted as for the presence or absence of the warpage and the degree of the warpage of the sapphire substrate during and after the formation of the multilayer film, the first heat-denatured layer, and the second heat-denatured layer provided as needed.

First, thermal cleaning is performed on the side of a film formation surface 52 of a sapphire substrate 50 (single crystal substrate 20) before the start of the film formation (FIG. 6A). Next, on the film formation surface 52, a low-temperature buffer layer 60 (FIG. 6B), an n-GaN layer 62 (FIG. 6C), and an InGaN-based active layer 64 having the multi-quantum well structure (FIG. 6D) are grown in the stated order. With this, a multilayer film 70 (multilayer film 30) formed of three layers is formed on one surface of the sapphire substrate 50. After that, by performing a predetermined subsequent step, it is possible to obtain a light emitting element such as an LED chip. Note that, each layer constituting the multilayer film 70 can be formed by using, for example, the MOCVD method, the HVPE method, and the MBE method.

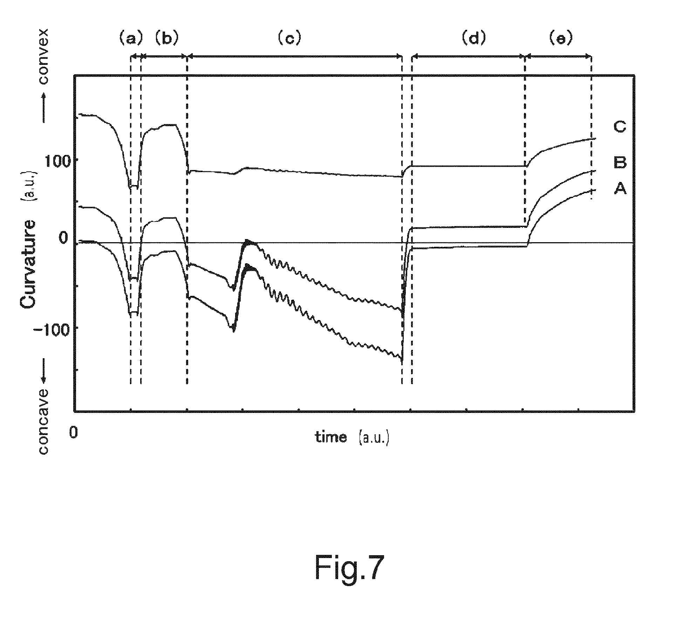

Next, the warpage behavior of the single crystal substrate 20 in the multilayer film formation step is described. FIG. 7 is a graph showing an example of the warpage behavior of the single crystal substrate in the multilayer film formation step. Specifically, FIG. 7 is a graph showing the warpage behavior of the sapphire substrate during the formation of the multilayer film 70 illustrated in FIGS. 6. In FIG. 7, the horizontal axis represents time, while the vertical axis represents the curvature of the sapphire substrate 50 at the film formation surface 52. Note that, the positive direction of the vertical axis represents a state in which the sapphire substrate 50 is convexly warped toward the side of the film formation surface 52, while the negative direction of the vertical axis represents a state in which the sapphire substrate 50 is concavely warped on the side of the film formation surface 52.

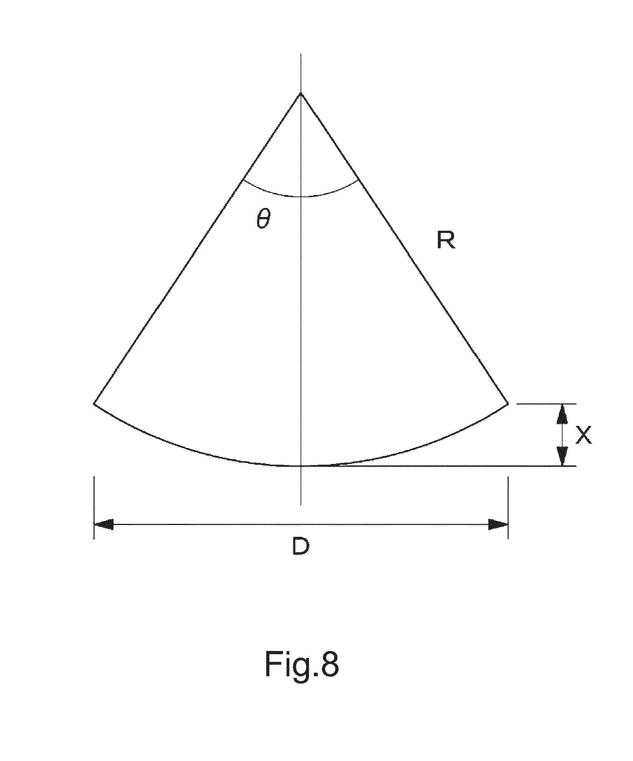

Note that, the warpage behavior of the sapphire substrate 50 during the multilayer film formation step as shown in FIG. 7 can be grasped by using an in-situ observation method disclosed in Non Patent Literature 2. In addition, from the curvature of the substrate represented by the vertical axis of FIG. 7, the warpage amount of the substrate can be calculated. FIG. 8 is a schematic explanatory diagram illustrating a method of calculating the warpage amount of the substrate from the curvature of the circular substrate. In FIG. 8, the curvature radius of the substrate is represented by R, the warpage amount of the substrate having the curvature of 1/R is represented by X, and the approximate diameter of the substrate is represented by D. With use of the Pythagorean theorem for the relationship among those values, (1/R)²=((1/R)-X)²+(D/2)² can be given. Based on this expression, the warpage amount (µm) can be determined by 0.322 × the curvature (km⁻¹) when the diameter of the substrate is 50 mm, and the warpage amount (µm) can be determined by 1.250 × the curvature (km⁻¹) when the diameter of the substrate is 100 mm.

Among three Spectrums representing changes in warpage behavior shown in FIG. 7, Spectrum A represents a change in warpage behavior in a case where the multilayer film 70 is formed by using the sapphire substrate 50 in which the second heat-denatured layer is not formed. On the other hand, each of Spectrums B and C represents a change in warpage behavior in a case where the multilayer film 70 is formed under the same conditions as those in the measurement of Spectrum A except that the second heat-denatured layer is formed in the sapphire substrate 50 in advance. Spectrum B differs from Spectrum C because the second heat-denatured layer is formed in the internal portion of the sapphire substrate 50 so that the curvature (about +150 km⁻¹ as a relative value in FIG. 7) of the sapphire substrate 50 by itself used in the measurement of Spectrum C is larger than the curvature (about +50 km⁻¹ as a relative value in FIG. 7) of the sapphire substrate 50 by itself used in the measurement of Spectrum B. That is, it can be said that the rigidity of the sapphire substrate 50 used in the measurement of Spectrum B, in which the second heat-denatured layer is formed in advance, is improved as compared with that of the sapphire substrate 50 used in the measurement of Spectrum A, due to the provision of the second heat-denatured layer.

Note that, in the example shown in FIG. 7, the second heat-denatured layer provided in the internal portion of the sapphire substrate 50 used in the measurement of Spectrum B and the second heat-denatured layer provided in the internal portion of the sapphire substrate 50 used in the measurement of Spectrum C are each provided at a position at the same depth from the side of the film formation surface 52 in the thickness direction of the sapphire substrate 50, and the second heat-denatured layers in the planar direction of the sapphire substrates 50 are each provided to have the lattice pattern. However, by varying pitches between the lines constituting the lattice pattern, the sapphire substrate 50 used in the measurement of Spectrum C has the total area of the second heat-denatured layer in the planar direction of the sapphire substrate 50 larger than that of the sapphire substrate 50 used in the measurement of Spectrum B. Accordingly, the curvature of the sapphire substrate 50 used in the measurement of Spectrum C is larger than the curvature of the sapphire substrate 50 used in the measurement of Spectrum B.

In addition, sections indicated as (a) to (e) along the horizontal axis of FIG. 7 correspond to respective processes sequentially performed in the multilayer film formation step. Process (a) corresponds to the process of performing thermal cleaning on the film formation surface 52 of the sapphire substrate 50. Process (b) corresponds to the process of forming the low-temperature buffer layer 60. Process (c) corresponds to the process of forming the n-GaN layer 62. Process (d) corresponds to the process of forming the InGaN-based active layer 64. Process (e) corresponds to the process of performing cooling down.

Next, the change in the warpage behavior of Spectrum A shown in FIG. 7 is described. First, in (a) the process of thermal cleaning of the film formation surface 52, the sapphire substrate 50 is warped in such a direction that the film formation surface 52 becomes concave (negative side in the vertical axis in FIG. 7) due to a difference in temperature between the film formation surface 52 of the sapphire substrate 50 and a non-film formation surface 54 thereof, and hence the curvature greatly changes. Subsequently, in (b) the process of forming the low-temperature buffer layer 60, the temperature of the sapphire substrate 50 is reduced to be lower than the temperature during (a) the process of thermal cleaning of the film formation surface 52, and the temperature is usually maintained at about 500°C to 600°C. As a result, the sapphire substrate 50 is warped in such a direction that the film formation surface 52 becomes convex (positive side in the vertical axis in FIG. 7), and the absolute value of the curvature is reduced.

Then, in (c) the process of forming the n-GaN layer 62, the temperature of the sapphire substrate 50 is increased to about 1,000°C again, and the n-GaN layer 62 is formed. In this process, the sapphire substrate 50 is warped in such a direction that the film formation surface 52 becomes concave due to a difference in lattice constant between gallium nitride and sapphire, and the absolute value of the curvature is increased. As the film formation progresses and the film thickness is increased, the absolute value of the curvature is increased. As a result, the uniformity of each of the film thickness and the film quality in the surface of the substrate is significantly deteriorated. Note that, it is technically extremely difficult to significantly improve the uniformity of the film in the surface of the substrate only by using film formation conditions unless the composition and the film thickness of the film to be formed are changed. In addition, as shown by Process (c) of Spectrum A, when the warpage of the substrate is increased, a stress occurs in the internal portion of the nitride semiconductor crystal layer. As a result, a problem arises that dislocation occurs in the nitride semiconductor crystal layer in order to relieve the stress and the film quality is thereby deteriorated.

Next, in (d) the process of forming the InGaN-based active layer 64, the temperature of the sapphire substrate 50 is reduced to about 700°C to 800°C, and the InGaN-based active layer 64 is formed. Herein, in a case where a light emitting element such as an LED chip is manufactured by performing a predetermined subsequent step on the sapphire substrate 50 with the multilayer film 70 illustrated in FIG. 6D, the uniformity of each of the film thickness of the InGaN-based active layer 64 and an In composition in the InGaN-based active layer 64 influences the in-surface uniformity of an emission wavelength, and by extension influences the manufacturing yield of the light emitting element. The uniformity of each of the film thickness of the InGaN-based active layer 64 and the In composition in the InGaN-based active layer 64 is influenced by the film formation temperature. Consequently, in (d) the process of forming the InGaN-based active layer 64, in order to improve the uniformity of the temperature in the surface of the substrate, it is desirable to cause the curvature of the sapphire substrate 50 during the film formation to approach 0 as much as possible. Note that, in the example represented as Spectrum A, the curvature in Process (d) is maintained in the vicinity of substantially 0.

Subsequently, in (e) the process of cooling down the sapphire substrate 50 having the multilayer film 70 formed thereon, the sapphire substrate 50 is warped in such a direction that the sapphire substrate 50 becomes convex toward the side of the film formation surface 52 due to a difference in thermal expansion coefficient between the multilayer film 70 and the sapphire substrate 50, and the absolute value of the curvature is increased. In addition, a compressive stress occurs in the multilayer film 70 in the process of the cooling down to the vicinity of room temperature. In order to release the compressive stress, the state in which the sapphire substrate 50 is warped convexly toward the side of the film formation surface 52 is maintained even after the end of the cooling down. However, the above-mentioned warpage can be corrected by performing the heat-denatured layer formation step after multilayer film formation and, through optimization of the disposition pattern of the first heat-denatured layer 22, the curvature can be set to a value in the vicinity of 0. In this case, even when various subsequent steps such as patterning and back lapping processes are performed in order to obtain the light emitting element such as an LED chip, it is possible to reliably suppress variations in quality and a reduction in yield of the light emitting element that result from the warpage.

### (Element manufacturing method)

By performing various subsequent steps on the single crystal substrate with a multilayer film according to this embodiment produced by the above-mentioned manufacturing process, it is possible to produce elements. In this case, in the subsequent step, by performing at least an element portion formation step of performing at least a patterning process on the multilayer film 30 to produce an element portion functioning as any one selected from the group consisting of a light emitting element, a photovoltaic element, and a semiconductor element, it is possible to manufacture an element including the element portion and a single crystal substrate having a size substantially corresponding to the element portion. Here, the layer structure of the multilayer film 30 is appropriately selected in accordance with the type of element to be finallyproduced. In addition, in the manufacturing of the element, besides the element portion formation step, a polishing step, a line-for-division formation step, and a division step may be performed in the stated order as subsequent steps.

In this case, in a manufacturing method for an element using the single crystal substrate with a multilayer film according to this embodiment, specifically, by successively performing at least steps (1) to (4) described below, it is possible to produce the element including the element portion and the single crystal substrate having the size substantially corresponding to the element portion.
(1) An element portion formation step of patterning the multilayer film of the single crystal substrate with a multilayer film according to this embodiment to form individual element portions.
(2) A polishing step of polishing, at least until the first heat-denatured layer formed in the heat-denatured layer formation step after multilayer film formation is removed, the surface of the single crystal substrate with the element portions on which the element portions are not formed, the single crystal substrate with the element portions having the element portions formed on the one surface thereof.
(3) A line-for-division formation step of applying a laser along a boundary line between the individual element portions from the side of the surface polished in the polishing step to form a line for division.
(4) A division step of applying an external force along the line for division formed in the line-for-division formation step to divide the single crystal substrate with the element portions based on each element portion.
Herein, when (3) the line-for-division formation step and (4) the division step are performed, it is possible to use the technology described in Patent Literature 3.

Note that, when the first heat-denatured layer is formed into the lattice pattern, it is theoretically possible to perform the division step by using, after the first heat-denatured layer is polished in the polishing step to such an extent that the first heat-denatured layer is not completely removed, the first heat-denatured layer remaining in the single crystal substrate as the line for division. However, it is not possible to confirm the positions at which the element portions are present and to perform alignment for the laser irradiation before the multilayer film is individualized into individual element portions. Consequently, in the above-mentioned method in which the heat-denatured layer functioning also as the line for division is formed before the individual element portions are produced, it is difficult to accurately form the line for division in correspondence to the individual element portions. That is, in the above-mentioned method, the line for division is more prone to be deviated from the boundary line between two adjacent element portions. Thus, the above-mentioned method tends to lack practicality. Consequently, when the division step is performed by using the heat-denatured layer formed by the laser irradiation, it is especially preferable to perform the above-mentioned steps (1) to (4) in this order.

When the line-for-division formation step is performed, as the laser irradiation condition, it is especially desirable to select Irradiation Condition B described above. In the case of Irradiation Condition A in which the laser wavelength is in the ultraviolet region, the laser energy resulting from the laser wavelength is large, and hence the width of the line for division to be formed is large and the width becomes likely to be varied in the length direction of the line. As a result, in the division step, there are cases where it becomes difficult to perform linear and accurate division.

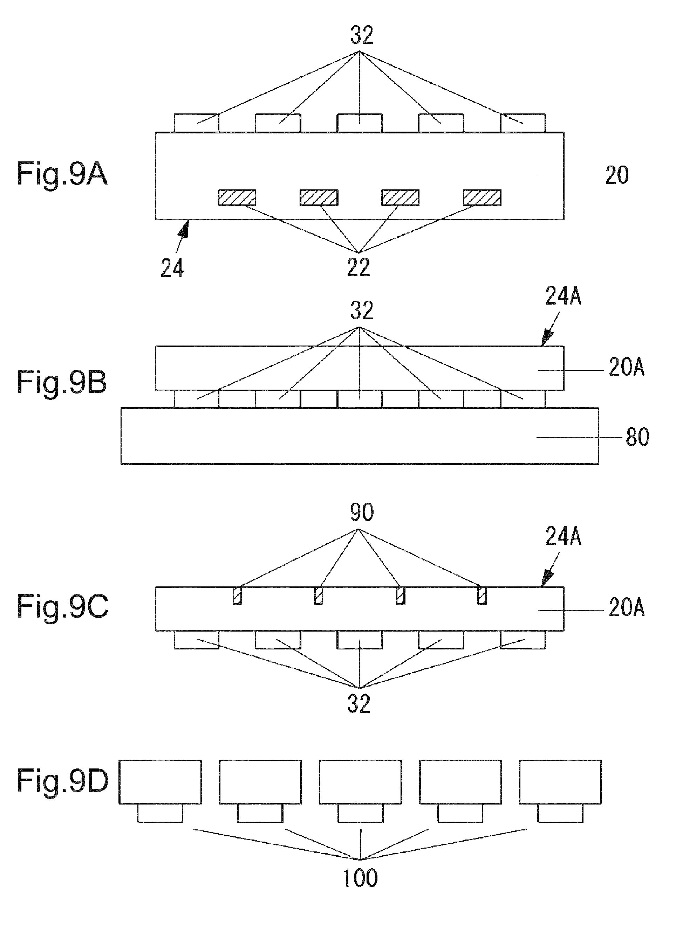

FIGS. 9 are schematic explanatory diagrams illustrating an example of the element manufacturing method according to this embodiment. Specifically, FIGS. 9 illustrate an example of a case where, with use of the substrate with a film after laser processing 12 illustrated in the lower part of FIG. 1, (1) the element portion formation step (FIG. 9A), (2) the polishing step (FIG. 9B), (3) the line-for-division formation step (FIG. 9C), and (4) the division step (FIG. 9D) are performed in the stated order. Note that, in FIGS. 9, components having the same functions and structures as those illustrated in FIG. 1 are represented by the same reference symbols, and illustration is omitted as for the presence or absence and the degree of the warpage of the single crystal substrate 20.

First, by performing the patterning process on the multilayer film 30 of the substrate with a film after laser processing 12 illustrated in the lower part of FIG. 1, the multilayer film 30 is separated so as to form a plurality of individual element portions 32. Herein, the patterning process may be performed, for example, in the following manner. First, a resist film is formed on the multilayer film 30, patterning is then performed by exposing and developing the resist film using a photomask, and the resist film is partially removed. Thereafter, the multilayer film 30 in the portion from which the resist film is removed is removed by etching, and the element portions 32 are thereby formed (FIG. 9A). Then, through bonding of the surface having the element portions 32 formed thereon and a flat polishing board 80 to each other, the single crystal substrate 20 having the element portions 32 formed thereon is fixed onto the polishing board 80, and the side of the non-film formation surface 24 is polished. This polishing is performed until at least the first heat-denatured layer 22 is completely removed (FIG. 9B). Thereafter, through irradiation of the laser from the side of a non-film formation surface that has been polished 24A, lines for division 90 are formed. Each of the lines for division 90 is formed between two element portions 32 adjacent to each other in the planar direction of a single crystal substrate that has been polished 20A (FIG. 9C). Lastly, through application of an external force along the line for division 90, the single crystal substrate 20 is divided for each element portion 32, and thus a plurality of elements 100 are obtained (FIG. 9D).

Note that, from the viewpoint of facilitating the polishing (back lapping process) of the non-film formation surface 24 and securing the yield, basically, it becomes more preferable as the warpage of the single crystal substrate 20 having the element portions 32 formed thereon illustrated in FIG. 9A is further reduced.

The reason for this is as follows. First, assumed that, in the single crystal substrate 20 with the element portions 32 illustrated in FIG. 9A, the correction of the warpage by laser processing is not performed. In this case, the single crystal substrate 20 with the element portions 32 is in a significantly warped state. Then, even when the warped single crystal substrate 20 with the element portions 32 is bonded to the polishing board 80 using a liquefied wax, the outer edge side of the non-film formation surface 24 of the single crystal substrate 20 with the element portions 32 fixed to the polishing board 80 is significantly warped upward, or the non-film formation surface 24 is significantly undulated. In this case, when the back lapping process is performed, variations in polishing amount in the surface of the single crystal substrate 20 become likely to occur. Such a phenomenon is generally seen when there is used the substrate with a film before laser processing 10 in which the correction of the warpage by the laser processing is not performed as illustrated in the upper part of FIG. 1.

However, when the single crystal substrate 20 with the element portions 32 that has no warpage is bonded to the polishing board 80, bubbles become likely to remain in the layer of a solidified wax present at the interface between the single crystal substrate 20 with the element portions 32 and the polishing board 80 that have been bonded together. As the result, the non-film formation surface 24 of the single crystal substrate 20 with the element portions 32 fixed to the polishing board 80 becomes likely to be undulated, though not as markedly as that in the case where the warped single crystal substrate 20 with the element portions 32 is used. Note that, the reason why the bubbles remain in the solidified wax layer is presumed to be as follows.

First, when the non-film formation surface 24 of the single crystal substrate 20 with the element portions 32 is significantly warped concavely, the liquid wax present between the single crystal substrate 20 and the polishing board 80 flows so as to be pushed from the central portion at the interface of the bonding toward the outer edge portion side during the bonding. This is because, when the single crystal substrate 20 with the element portions 32 is bonded and fixed to the polishing board 80, a pressing force is applied to the entire surface of the non-film formation surface 24 of the single crystal substrate 20 with the element portions 32 so that the warpage of the single crystal substrate 20 with the element portions 32 is flattened. In this case, bubbles trapped in the bonding interface at the time of the bonding can easily move to the outer edge portion side of the bonding interface along with the flowing of the liquidwax. Therefore, after the wax is solidified at the bonding interface, it is difficult for the bubbles to remain in the solidified wax layer.

However, when the single crystal substrate 20 with the element portions 32 that has no warpage is bonded to the polishing board 80, during the entire period from when the bonding is started to when the liquid wax is solidified and the bonding is completed, a uniform pressing force is applied to the entire surface of the bonding interface. As a result, the fluidity of the liquid wax present at the bonding interface in the planar direction is lowered. Accordingly, it becomes difficult for the bubbles trapped in the bonding interface at the time of the bonding to move from the central portion side of the bonding interface to the outer edge portion side. Therefore, after the wax is solidified at the bonding interface, the bubbles are likely to remain in the solidified wax layer.

In view of the point described above, the single crystal substrate 20 with the element portions 32 is more preferably in a state in which the non-film formation surface 24 is slightly warped concavely than in a state in which the non-film formation surface 24 has no warpage. In this case, because the laser processing is not performed for the correction of the warpage, it is possible to solve both of the problem resulting from the state in which the non-film formation surface 24 is significantly warped concavely and the problem resulting from the state in which the non-film formation surface 24 is completely flat. That is, it is possible to solve both of the problem that, due to the significant warpage of the non-film formation surface 24, the outer edge side of the non-film formation surface 24 is significantly warped upward or the non-film formation surface 24 is significantly undulated after the bonding, and the problem that bubbles remain in the solidified wax layer and the non-film formation surface 24 thereby becomes likely to be undulated.

In this case, the non-film formation surface 24 of the single crystal substrate 20 with the element portions 32 is slightly warped concavely, and hence it is extremely easy to flatten the non-film formation surface 24 at the time of the bonding. In addition to this, at the time of the bonding, the liquid wax present between the single crystal substrate 20 and the polishing board 80 flows so as to be pushed from the central portion at the bonding interface to the outer edge portion side. As a result, at the time of the bonding, it is difficult for the bubbles trapped in the bonding interface to remain in the layer of the wax solidified after the bonding.

Herein, it is possible to easily achieve the state in which the non-film formation surface 24 of the single crystal substrate 20 with the element portions 32 is slightly warped concavely by appropriately selecting the laser irradiation conditions when the first heat-denatured layer 22 is formed and the laser irradiation conditions when the second heat-denatured layer 28 that is provided as needed is formed.

### Examples

The present invention is described hereinbelow by way of Examples, but the present invention is not limited only to the following Examples. Hereinbelow, description is made of Examples, which are broadly divided into a case where the first heat-denatured layer is formed by the laser irradiation after the multilayer film is formed on the sapphire substrate (Example in which the laser irradiation is performed once) and a case where the first heat-denatured layer is formed by the laser irradiation after the multilayer film is formed on the sapphire substrate in which the second heat-denatured layer is formed by the laser irradiation (Example in which the laser irradiation is performed twice).

### <<Example in which laser irradiation is performed once>>

### (Production of sample for evaluation)

As a sample for evaluation, a sample in which the multilayer film 70 including three layers was formed on one surface of the sapphire substrate 50 similar to that illustrated in FIG. 6D was produced according to the following procedures. First, the multilayer film 70 was formed on the film formation surface 52 of the sapphire substrate 50, and then the first heat-denatured layer 22 was formed so as to have the lattice pattern by the laser irradiation from the side of the non-film formation surface 54. In this manner, the sapphire substrate with a multilayer film was produced. At this time, evaluation was performed on the warpage amounts and the warpage directions, when viewed from the film formation surface side, before and after the laser irradiation after the formation of the multilayer film, and on the relationship of the change amounts of the warpage amount before and after the laser irradiation with respect to the pitch between lines at the time of the laser irradiation. Hereinbelow, the details of test conditions and the evaluation results are described.

### -Sapphire substrate-

As the sapphire substrate 50, a circular sapphire substrate provided with an orientation flat plane (diameter: 4 inches (100 mm), thickness: 650 µm) was used. Note that, the sapphire substrate had one mirror-polished surface, and the multilayer film 70 was formed by using the mirror-polished surface as the film formation surface 52. In addition, the warpage amount of the sapphire substrate 50 under a state in which no film formation processing or laser irradiation processing was performed was in a range of ±30 µm.

### -Layer structure and film formation condition of multilayer film-

The multilayer film 70 including three layers was formed on the film formation surface 52 of the sapphire substrate 50. Specific film formation conditions were as follows, and the processes were performed in the order of (1) to (5) described below.

### (1) Thermal cleaning

After the sapphire substrate 50 was disposed in an MOCVD apparatus, thermal cleaning of the film formation surface 52 was performed for about 120 seconds at a substrate temperature of 1, 100 °C.

### (2) Formation of low-temperature buffer layer 60

The low-temperature buffer layer 60 was formed to a film thickness of 30 nmat a substrate temperature during the film formation of 530°C and a film formation rate of 0.16 nm/s.

### (3) Formation of n-GaN layer 62

The n-GaN layer 62 was formed to a film thickness of 3,500 nm at a substrate temperature during the film formation of 1, 050°C and a film formation rate of 2,000 nm/s.

### (4) Formation of InGaN-based active layer 64

The InGaN-based active layer 64 was formed to a film thickness of 408 nm at a substrate temperature during the film formation of 750°C and a film formation rate of 10 nm/s.

### (5) Cooling down

The sapphire substrate 50 having one surface on which the low-temperature buffer layer 60, the n-GaN layer 62, and the InGaN-based active layer 64 were formed in the stated order was cooled down to the vicinity of room temperature.

-Formation condition for first heat-denatured layer-First, the mirror polishing was performed on the non-film formation surface 54 of the single crystal substrate 50 having the multilayer film 70 formed thereon. Next, the sapphire substrate 50 was fixed onto a flat sample stage by vacuum suction so that the surface having the multilayer film 70 formed thereon was positioned to be the lower surface side. In this state, the laser irradiation was performed under the following irradiation conditions from the side of the non-film formation surface 54 of the sapphire substrate 50 in which the multilayer film 70 was not formed. In this manner, the first heat-denatured layer 22 was formed. Note that, during the laser irradiation, the sapphire substrate 50 was fixed onto the sample stage so that the scanning direction of the sample stage in the vertical direction corresponded to the orientation flat plane of the sapphire substrate 50. Subsequently, the sample stage was scanned relative to the laser irradiation apparatus in the vertical and lateral directions, and the first heat-denatured layer 22 was thereby formed so as to have the lattice pattern in the planar direction of the sapphire substrate. Herein, a sample in which the pitch between lines constituting the lattice pattern was changed was also produced by changing the scanning speed of the sample stage.
• laser wavelength: 1,045 nm
• pulse width: 500 fs
• pulse rate: 100 kHz
• spot size: 1.6 µm to 3.5 µm
• laser power: 0.3 W
• scanning speed of sample stage: 400 mm/s (appropriately selected depending on the pitch between lines within the range mentioned in the left)

### (Evaluation result)

### -Evaluation of warpage amount and warpage direction-

Table 2 shows the result of evaluation of the warpage amounts and the warpage directions, when viewed from the film formation surface side, before and after the laser irradiation after the formation of the multilayer film, together with laser irradiation conditions other than those described above. As shown in Table 2, it was found that the warpage amount was increased to about 70 µm by the formation of the multilayer film 70, but the warpage resulting from the formation of the multilayer film 70 was corrected by the formation of the first heat-denatured layer 22 in the internal portion of the sapphire substrate 50 by the laser irradiation, and the warpage amount was reduced to about 5 µm.

**[Table 2]**

| | After formation of multilayer film and before laser irradiation | | Laser irradiation conditions after formation of multilayer film | | | After laser irradiation | |
|---|---|---|---|---|---|---|---|
| | Warpage amount (µm) | Warpage direction when viewed from film formation surface side | Presence of laser irradiation | Pitch between lines (µm) | Depth of laser focus from non-film formation surface (µm) | Warpage amount (µm) | Warpage directi on when viewed from film formati on surface side |
| Example A1 | 76 | Convex | Yes | 300 | 110 | 2 | Convex |
| Example A2 | 66 | Convex | Yes | | | 0 | - |
| Example A3 | 71 | Convex | Yes | | | 10 | Convex |
| Example A4 | 66 | Convex | Yes | | | 2 | Convex |
| Example A5 | 71 | Convex | Yes | | | 5 | Convex |
| Comparative Example A1 | 71 | Convex | No | - | - | - | - |

### -Change amount of warpage amount before and after laser irradiation-

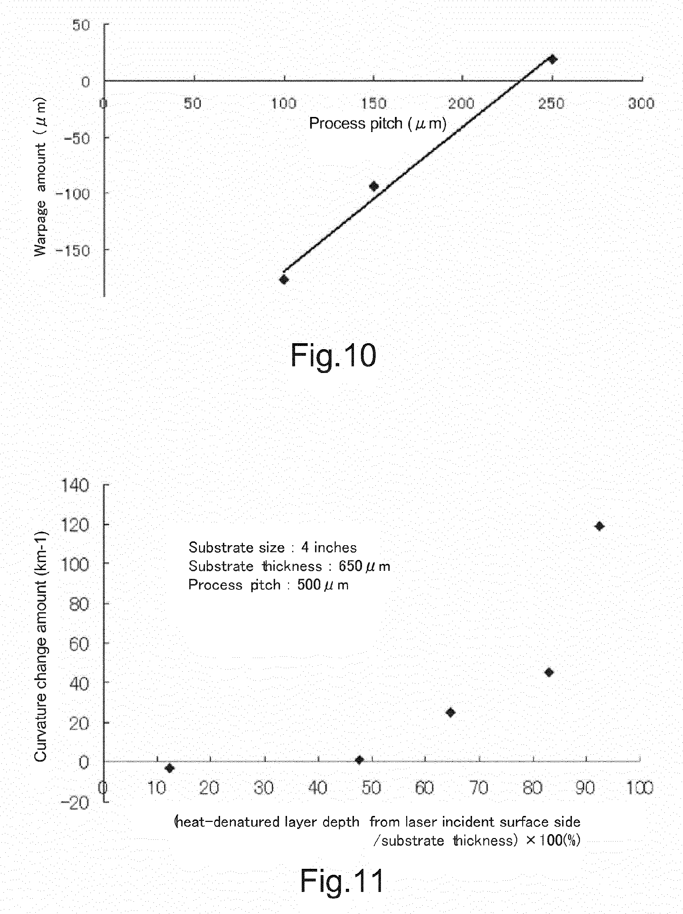

In addition, FIG. 10 shows the change amount of the warpage amount (µm, the warpage amount before the laser irradiation - the warpage amount after the laser irradiation) before and after the laser irradiation after the formation of the multilayer film when, under the test conditions of Examples A1 to A5 shown in Table 2, only the pitch between the lines is changed. As is clear from FIG. 10, it was found that, through reduction of the pitch between lines, that is, through increase of the formation region of the first heat-denatured layer 22 in the planar direction of the sapphire substrate 50, the change amount of the warpage amount before and after the laser irradiation was increased. From this, it was found that, whatever the value of the warpage amount of the sapphire substrate 50 after the formation of the multilayer film was, through appropriate selection of the formation region of the first heat-denatured layer 22 in the planar direction of the sapphire substrate 50, it was possible to cancel out the warpage amount resulting from the formation of the multilayer film 70 by a desired amount. Therefore, from the result shown in FIG. 10, it can be said that, for example, in a case where the warpage amount after the formation of the multilayer film is about 100 µm, when the warpage resulting from the formation of the above-mentioned multilayer film 70 is to be corrected by the laser irradiation until the sapphire substrate 50 is brought into a substantially flat state, it is sufficient to set the pitch between lines to 150 µm and perform the laser irradiation.

### (Evaluation method)

The warpage amount shown in each of Table 2 and FIG. 10 was measured using a linear gauge. Note that, the warpage amount was verified and confirmed also using a laser interferometer. In addition, the warpage direction when viewed from the film formation surface side, which is shown in Table 2, was measured using the laser interferometer.

### <<Example in which laser irradiation is performed twice>>

### (Production of sample for evaluation)

As a sample for evaluation, a sample in which the multilayer film 70 including three layers was formed on one surface of the sapphire substrate 50 similar to that illustrated in FIG. 6D was produced according to the following procedures. First, the second heat-denatured layer 28 was formed so as to have the lattice pattern by the laser irradiation from the side of the film formation surface 52 of the sapphire substrate 50, the multilayer film 70 was then formed on the film formation surface 52, and thereafter the first heat-denatured layer 22 was formed so as to have the lattice pattern by the laser irradiation from the side of the non-film formation surface 54. In this manner, the sapphire substrate with a multilayer film was produced. At this time, evaluation was performed on the warpage amounts and the warpage directions, when viewed from the film formation surface side, before and after the laser irradiation before the formation of the multilayer film, on the warpage amounts and the warpage directions, when viewed from the film formation surface side, before and after the laser irradiation after the formation of the multilayer film, on the relationship of the change in warpage amount before and after the laser irradiation with respect to the pitch between lines at the time of the laser irradiation after the formation of the multilayer film, and on a difference between maximum and minimum values of the curvature of the sapphire substrate during the formation of the multilayer film. Hereinbelow, the details of test conditions and the evaluation results are described.

### -Sapphire substrate-

As the sapphire substrate 50, a circular sapphire substrate provided with an orientation flat plane (diameter: 2 inches (50.8 mm), thickness: 430 µm) was used. Note that, the sapphire substrate 50 had one mirror-polished surface, and the multilayer film 70 was formed by using the mirror-polished surface as the film formation surface 52. In addition, the warpage amount of the sapphire substrate 50 under a state in which no film formation processing or laser irradiation processing was performed was in a range of ±10 µm.

-Formation condition for second heat-denatured layer-The formation of the second heat-denatured layer 28 was performed by performing the laser irradiation from the side of the film formation surface 52 under the following irradiation conditions in a state in which the sapphire substrate 50 was disposed on the flat sample stage so that the film formation surface 52 was positioned as the upper surface and the sapphire substrate 50 was fixed by vacuum suction. Note that, during the laser irradiation, the sapphire substrate 50 was fixed onto the sample stage so that the scanning direction of the sample stage in the vertical direction corresponded to the orientation flat plane of the sapphire substrate 50. Subsequently, the sample stage was scanned relative to the laser irradiation apparatus in the vertical and lateral directions, and the second heat-denatured layer 28 was formed so as to have the lattice pattern in the planar direction of the sapphire substrate 50. Herein, the pitch between lines was changed by changing the scanning speed of the sample stage.
• laser wavelength: 1,045 nm
• pulse width: 500 fs
• pulse rate: 100 kHz
• spot size: 1.6 µm to 3.5 µm
• laser power: 0.3 W
• scanning speed of sample stage: 400 mm/s (appropriately selected depending on the pitch between lines within the range mentioned in the left)

### -Layer structure and film formation condition of multilayer film-

The multilayer film 70 including three layers was formed on the film formation surface 52 of the sapphire substrate 50 in which the second heat-denatured layer 28 was formed. Specific film formation conditions were as follows, and the processes were performed in the order of (1) to (5) described below.

### (1) Thermal cleaning

After the sapphire substrate 50 was disposed in an MOCVD apparatus, thermal cleaning of the film formation surface 52 was performed for about 120 seconds at a substrate temperature of 1, 100 °C.

### (2) Formation of low-temperature buffer layer 60

The low-temperature buffer layer 60 was formed to a film thickness of 30 nmat a substrate temperature during the film formation of 530°C and a film formation rate of 0.16 nm/s.

### (3) Formation of n-GaN layer 62

The n-GaN layer 62 was formed to a film thickness of 3,500 nm at a substrate temperature during the film formation of 1, 050°C and a film formation rate of 2,000 nm/s.

### (4) Formation of InGaN-based active layer 64

The InGaN-based active layer 64 was formed to a film thickness of 408 nm at a substrate temperature during the film formation of 750°C and a film formation rate of 10 nm/s.

### (5) Cooling down

The sapphire substrate 50 having one surface on which the low-temperature buffer layer 60, the n-GaN layer 62, and the InGaN-based active layer 64 were formed in the stated order was cooled down to the vicinity of room temperature.

### -Formation condition for first heat-denatured layer-

First, the mirror polishing was performed on the non-film formation surface 54 of the single crystal substrate 50 having the multilayer film 70 formed thereon. Next, the sapphire substrate 50 was fixed onto a flat sample stage by vacuum suction so that the surface having the multilayer film 70 formed thereon was positioned to be the lower surface side. In this state, the laser irradiation was performed under the following irradiation conditions from the side of the non-film formation surface 54 of the sapphire substrate 50 in which the multilayer film 70 was not formed. In this manner, the first heat-denatured layer 22 was formed. Note that, during the laser irradiation, the sapphire substrate 50 was fixed onto the sample stage so that the scanning direction of the sample stage in the vertical direction corresponded to the orientation flat plane of the sapphire substrate 50. Subsequently, the sample stage was scanned relative to the laser irradiation apparatus in the vertical and lateral directions, and the first heat-denatured layer 22 was thereby formed so as to have the lattice pattern in the planar direction of the sapphire substrate 50. Herein, a sample in which the pitch between lines constituting the lattice pattern was changed was also produced by changing the scanning speed of the sample stage.
• laser wavelength: 1,045 nm
• pulse width: 500 fs
• pulse rate: 100 kHz
• spot size: 1.6 µm to 3.5 µm
• laser power: 0.3 W
• scanning speed of sample stage: 400 mm/s (appropriately selected depending on the pitch between lines within the range mentioned in the left)

### (Evaluation result)

### -Evaluation of warpage amount and warpage direction-

Table 3 shows the result of evaluation of the warpage amounts and the warpage directions, when viewed from the film formation surface 52 side, before and after the laser irradiation before the formation of the multilayer film, and the warpage amounts and the warpage directions, when viewed from the film formation surface 52 side, before and after the laser irradiation after the formation of the multilayer film. As shown in Table 3, in each of Examples, the warpage amount was increased by the first laser irradiation before the formation of the multilayer film, and the warpage amount was further increased with respect to the above-mentioned warpage amount after the formation of the multilayer film. However, the warpage amount after the second laser irradiation after the formation of the multilayer film was larger than that before the first laser irradiation before the formation of the multilayer film, but was smaller than that after the first laser irradiation before the formation of the multilayer film. From this result, it was found that it was possible to completely cancel out the warpage resulting from the formation of the multilayer film by virtue of the second laser irradiation after the formation of the multilayer film, and further cancel out the warpage resulting from the first laser irradiation before the formation of the multilayer film to some extent as well.

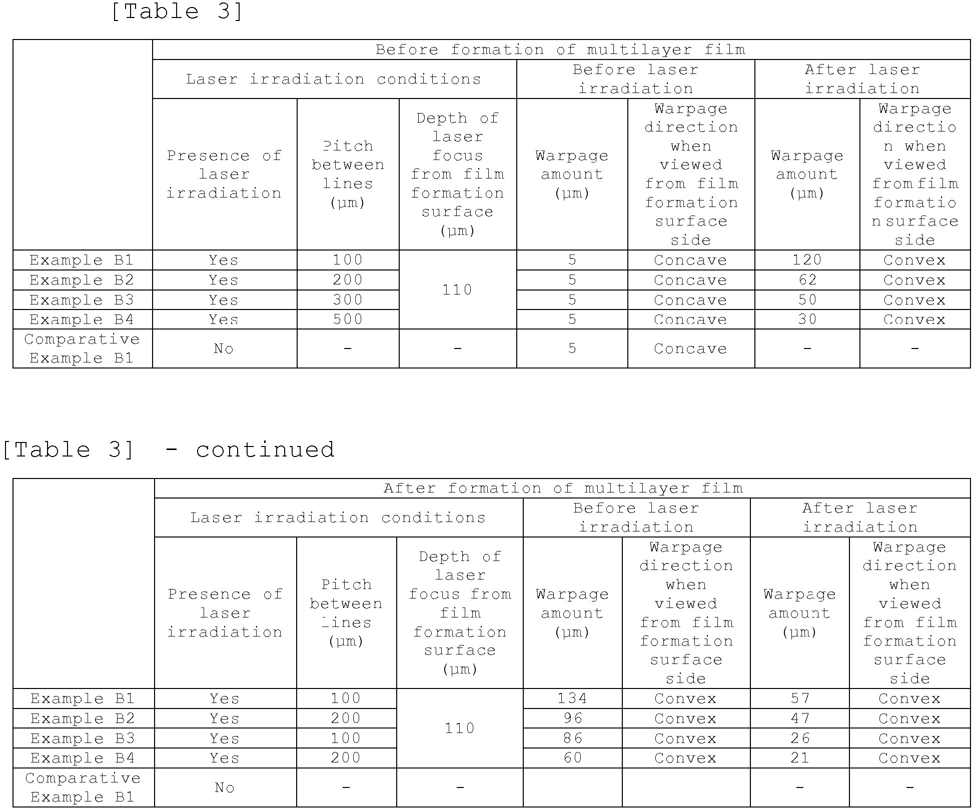

### -Difference between maximum and minimum values of curvature during formation of multilayer film-

Table 4 shows the result of measurement of a difference between maximum and minimum values of the curvature of the sapphire substrate during the formation of the multilayer film in each of Examples B1 to B4 and Comparative Example B1 shown in Table 3. As shown in Table 4, it was found that, in each of Examples, the warpage behavior during the formation of the multilayer filmwas suppressed as compared with Comparative Example B1. Further, as shown in each of Examples B1 to B4, it was found that, as the pitch between lines at the time of the first laser irradiation was reduced, the warpage behavior during the formation of the multilayer film was further suppressed.

**[Table 4]**

| | Difference between maximum and minimum values of curvature during formation of multilayer film (%) |
|---|---|
| Example B1 | 84 |
| Example B2 | 86 |
| Example B3 | 88 |
| Example B4 | 90 |
| Comparative Example B1 | 100 |

### (Evaluation method)

The warpage amount shown in Table 3 was measured using a linear gauge. Note that, the warpage amount was verified and confirmed also using a laser interferometer. In addition, the warpage direction when viewed from the film formation surface 52 side, which is shown in Table 3, was measured using the laser interferometer. Further, the maximum and minimum values of the curvature during the formation of the multilayer film shown in Table 4 were measured by utilizing the in-situ observation method disclosed in Non Patent Literature 2 during a period from immediately after the start of (1) the thermal cleaning to the end of (5) the cooling down.

### <<Example in which laser irradiation is performed once with regard to change amount of curvature in thickness direction of single crystal substrate>>

### (Production of sample for evaluation)

As a sample for evaluation, a sample in which the multilayer film 70 including three layers was formed on one surface of the sapphire substrate 50 similar to that illustrated in FIG. 6D was produced according to the following procedures. First, the multilayer film 70 was formed on the film formation surface 52 of the sapphire substrate 50, and then the first heat-denatured layer 22 was formed so as to have the lattice pattern by the laser irradiation from the side of the non-film formation surface 54. In this manner, the sapphire substrate with a multilayer film was produced. At this time, evaluation was performed on the relationship of the change amount of the curvature of the sapphire substrate 50 with respect to the thickness direction of the sapphire substrate 50 as the formation position of the heat-denatured layer 22. Hereinbelow, the details of the test conditions and the evaluation results are described.

### -Sapphire substrate-

As the sapphire substrate 50, a circular sapphire substrate provided with an orientation flat plane (diameter: 4 inches (100 mm), thickness: 650 µm) was used. Note that, the sapphire substrate had one mirror-polished surface, and the multilayer film 70 was formed by using the mirror-polished surface as the film formation surface 52. In addition, the warpage amount of the sapphire substrate 50 under a state in which no film formation processing or laser irradiation processing was performed was in a range of ±30 µm.

### -Layer structure and film formation condition of multilayer film-

The multilayer film 70 including three layers was formed on the film formation surface 52 of the sapphire substrate 50. Specific film formation conditions were as follows, and the processes were performed in the order of (1) to (5) described below.

### (1) Thermal cleaning

After the sapphire substrate 50 was disposed in an MOCVD apparatus, thermal cleaning of the film formation surface 52 was performed for about 120 seconds at a substrate temperature of 1, 100 °C.

### (2) Formation of low-temperature buffer layer 60

The low-temperature buffer layer 60 was formed to a film thickness of 30 nmat a substrate temperature during the film formation of 530°C and a film formation rate of 0.16 nm/s.

### (3) Formation of n-GaN layer 62

The n-GaN layer 62 was formed to a film thickness of 3,500 nm at a substrate temperature during the film formation of 1, 050°C and a film formation rate of 2,000 nm/s.

### (4) Formation of InGaN-based active layer 64

The InGaN-based active layer 64 was formed to a film thickness of 408 nm at a substrate temperature during the film formation of 750°C and a film formation rate of 10 nm/s.

### (5) Cooling down

The sapphire substrate 50 having one surface on which the low-temperature buffer layer 60, the n-GaN layer 62, and the InGaN-based active layer 64 were formed in the stated order was cooled down to the vicinity of room temperature.

### -Formation condition for first heat-denatured layer-

First, the mirror polishing was performed on the non-film formation surface 54 of the single crystal substrate 50 having the multilayer film 70 formed thereon. Next, the sapphire substrate 50 was fixed onto a flat sample stage by vacuum suction so that the surface having the multilayer film 70 formed thereon was positioned to be the lower surface side. In this state, the laser irradiation was performed under the following irradiation conditions from the side of the non-film formation surface 54 of the sapphire substrate 50 in which the multilayer film 70 was not formed. In this manner, the first heat-denatured layer 22 was formed. Note that, during the laser irradiation, the sapphire substrate 50 was fixed onto the sample stage so that the scanning direction of the sample stage in the vertical direction corresponded to the orientation flat plane of the sapphire substrate 50. Subsequently, the sample stage was scanned relative to the laser irradiation apparatus in the vertical and lateral directions, and the first heat-denatured layer 22 was thereby formed so as to have the lattice pattern in the planar direction of the sapphire substrate. Herein, the pitch between lines constituting the lattice pattern was set to 500 µm.
• laser wavelength: 1,045 nm
• pulse width: 500 fs
• pulse rate: 100 kHz
• spot size: 1.6 µm to 3.5 µm
• laser power: 0.3 W
• scanning speed of sample stage: 400 mm/s (appropriately selected depending on the pitch between lines within the range mentioned in the left)

### (Evaluation result)

### -Evaluation of change amount of curvature of sapphire substrate with respect to thickness direction of sapphire substrate-

FIG. 11 shows the result of evaluation of the change amount of the curvature of the sapphire substrate 50 with respect to the thickness direction of the sapphire substrate 50. As shown in FIG. 11, it was found that, roughly from a point where the formation position of the first heat-denatured layer 22 exceeded 80%, the change amount of the curvature of the sapphire substrate 50 was sharply increased.

### (Evaluation method)

The change amount of the curvature shown in FIG. 11 was measured using a linear gauge. Note that, the change amount of the curvature was verified and confirmed also using a laser interferometer.

### <<Evaluation of bonding of single crystal substrate with multilayer film to polishing board>>

### (Production of sample for evaluation)

As a sample for evaluation, a sample in which the multilayer film 70 including three layers was formed on one surface of the sapphire substrate 50 similar to that illustrated in FIG. 6D was produced according to the following procedures. First, the multilayer film 70 was formed on the film formation surface 52 of the sapphire substrate 50, and then the first heat-denatured layer 22 was formed so as to have the lattice pattern by the laser irradiation from the side of the non-film formation surface 54. In this manner, the sapphire substrate with a multilayer film was produced. At this time, evaluation was performed on the warpage amounts and the warpage directions, when viewed from the film formation surface side, before and after the laser irradiation after the formation of the multilayer film, and on the relationship of the change amounts of the warpage amount before and after the laser irradiation with respect to the pitch between lines at the time of the laser irradiation. Hereinbelow, the details of test conditions and the evaluation results are described.

### -Sapphire substrate-

As the sapphire substrate 50, a circular sapphire substrate provided with an orientation flat plane (diameter: 4 inches (100 mm), thickness: 650 µm) was used. Note that, the sapphire substrate had one mirror-polished surface, and the multilayer film 70 was formed by using the mirror-polished surface as the film formation surface 52. In addition, the warpage amount of the sapphire substrate 50 under a state in which no film formation processing or laser irradiation processing was performed was in a range of ±30 µm.

### -Layer structure and film formation condition of multilayer film-

The multilayer film 70 including three layers was formed on the film formation surface 52 of the sapphire substrate 50. Specific film formation conditions were as follows, and the processes were performed in the order of (1) to (5) described below.

### (1) Thermal cleaning

After the sapphire substrate 50 was disposed in an MOCVD apparatus, thermal cleaning of the film formation surface 52 was performed for about 120 seconds at a substrate temperature of 1, 100 °C.

### (2) Formation of low-temperature buffer layer 60

The low-temperature buffer layer 60 was formed to a film thickness of 30 nmat a substrate temperature during the film formation of 530°C and a film formation rate of 0.16 nm/s.

### (3) Formation of n-GaN layer 62

The n-GaN layer 62 was formed to a film thickness of 3,500 nm at a substrate temperature during the film formation of 1, 050°C and a film formation rate of 2,000 nm/s.

### (4) Formation of InGaN-based active layer 64

The InGaN-based active layer 64 was formed to a film thickness of 408 nm at a substrate temperature during the film formation of 750°C and a film formation rate of 10 nm/s.

### (5) Cooling down

The sapphire substrate 50 having one surface on which the low-temperature buffer layer 60, the n-GaN layer 62, and the InGaN-based active layer 64 were formed in the stated order was cooled down to the vicinity of room temperature.

### -Formation condition for first heat-denatured layer-

First, the mirror polishing was performed on the non-film formation surface 54 of the single crystal substrate 50 having the multilayer film 70 formed thereon. Next, the sapphire substrate 50 was fixed onto a flat sample stage by vacuum suction so that the surface having the multilayer film 70 formed thereon was positioned to be the lower surface side. In this state, the laser irradiation was performed under the following irradiation conditions from the side of the non-film formation surface 54 of the sapphire substrate 50 in which the multilayer film 70 was not formed. In this manner, the first heat-denatured layer 22 was formed. Note that, during the laser irradiation, the sapphire substrate 50 was fixed onto the sample stage so that the scanning direction of the sample stage in the vertical direction corresponded to the orientation flat plane of the sapphire substrate 50. Subsequently, the sample stage was scanned relative to the laser irradiation apparatus in the vertical and lateral directions, and the first heat-denatured layer 22 was thereby formed so as to have the lattice pattern in the planar direction of the sapphire substrate. Herein, a sample in which the pitch between lines constituting the lattice pattern was changed was also produced by changing the scanning speed of the sample stage.
• laser wavelength: 1,045 nm
• pulse width: 500 fs
• pulse rate: 100 kHz
• spot size: 1.6 µm to 3.5 µm
• laser power: 0.3 W
• scanning speed of sample stage: 400 mm/s (appropriately selected depending on the pitch between lines within the range mentioned in the left)

### -Specifications of sample for evaluation-

Table 5 shows the warpage amounts and the warpage directions, when viewed from the side of the non-film formation surface 54, before and after the laser irradiation, of the single crystal substrate with the multilayer film 70 (Samples C1 to C5) used for evaluation, and the outline of laser irradiation conditions after the formation of the multilayer film. As is clear from Table 5, it was found that, in each of Samples C1 to C4 on which the laser processing was performed, the warpage amount was smaller and the warpage resulting from the formation of the multilayer film 70 was corrected as compared with Sample C5 on which the laser processing was not performed. Note that, the warpage amount shown in Table 5 was measured using a linear gauge. The warpage amount was verified and confirmed also using a laser interferometer. In addition, the warpage direction when viewed from the non-film formation surface 54 side, which is shown in Table 5, was measured using the laser interferometer.

**[Table 5]**

| | After formation of multilayer film and before laser irradiation | | Laser irradiation conditions after formation of multilayer film | | | After laser irradiation | |
|---|---|---|---|---|---|---|---|
| | Warpage amount (µm) | Warpage direction when viewed from non-film formation surface side | Presence of laser irradiation | Pitch between lines (µm) | Depth of laser focus from non-film formation surface (µm) | Warpage amount (µm) | Warpage direction when viewed from non-film formation surface side |
| Sample C1 | 93 | Concave | Yes | 200 | 110 | 11 | Concave |
| Sample C2 | 90 | Concave | Yes | 250 | | 34 | Concave |
| Sample C3 | 91 | Concave | Yes | 300 | | 42 | Concave |
| Sample C4 | 90 | Concave | Yes | 400 | | 52 | Concave |
| Sample C5 | 91 | Concave | No | - | - | - | - |

### -Bonding to polishing board-

For each Sample, the patterning process of the multilayer film 70 was omitted and the surface provided with the multilayer film 70 was bonded to the polishing board. As the polishing board 80, there was used an alumina board in which both surfaces thereof were formed flat and which had a diameter of 140 mm and a thickness of 20 mm. The warpage amounts of both the surfaces of the polishing board were measured using the linear gauge and the laser interferometer, which were ±1.5 µm in each of the measurement methods.

Next, after a wax liquefied by heating (melting point: about 120 degrees) was thinly and uniformly applied onto the entirety of one surface of the polishing board 80, Sample was disposed on the polishing board 80 to be bonded, and then another polishing board 80 was disposed on this Sample as a weight. Subsequently, through the polishing board 80 used as the weight, the load of 20 kg was uniformly applied to the entire surface of the bonding interface. Then, in this state, the wax was solidified by natural cooling, and Sample (single crystal substrate with a multilayer film) was thereby bonded onto the polishing board 80.

### (Evaluation result)

Regarding the non-film formation surface 54 of Sample bonded onto the polishing board 80, evaluation was performed on the warpage amount and the warpage direction, when viewed from the side of the non-film formation surface 54, in a direction in parallel to the orientation flat plane, and on the warpage amount and the warpage direction, when viewed from the side of the non-film formation surface 54, in a direction perpendicular to the orientation flat plane. In addition, through visual observation of the bonding interface from the side of the polishing board 80, it was evaluated whether or not bubbles were present at the bonding interface. The result is shown in Table 6.

**[Table 6]**

| | | | Example C1 | Example C2 | Example C3 | Example C4 | Comparative Example C1 |
|---|---|---|---|---|---|---|---|
| Sample | | | Sample C1 | Sample C2 | Sample C3 | Sample C4 | Sample C5 |
| Laser irradiation processing | | | Yes | Yes | Yes | Yes | No |
| Before bonding | Warpage amount of Sample (µm) | | 11 | 34 | 42 | 52 | 91 |
| | Warpage direction when viewed from non-film formation surface side | | Concave | Concave | Concave | Concave | Concave |
| After bonding | Direction in parallel to orientation flat plane | Warpage amount (µm) | 2 | 5 | 2 | 7 | 10 |
| | | Warpage direction when viewed from non-film formation surface side | Convex | Convex | Convex | Convex | Concave |
| | Direction perpendicular to orientation flat plane | Warpage amount (µm) | 4 | 7 | 3 | 7 | 13 |
| | | Warpage direction when viewed from non-film formation surface side | Convex | Convex | Convex | Convex | Concave |
| | Bubble at bonding interface | | Present | Present | Absent | Absent | Absent |

As is clear from Table 6, in each of Examples C1 to C4, it was observed that the warpage amount after the bonding to the polishing board 80 was 10 µm or less, and was smaller than the warpage amount of Comparative Example C1. In addition, in contrast to each of Examples C1 and C2 in which the warpage amount before the bonding was controlled so as to be about 40 µm or less, in each of Examples C3 and C4 in which the warpage amount before the bonding was controlled so as to be about 40 µm to 55 µm, the occurrence of bubbles at the bonding interface was not observed. Further, in Example C3 in which the warpage amount before the bonding was smaller than that in Example C4, it was possible to reduce the warpage amount after the bonding to a level similar to those in Examples C1 and C2. From the foregoing, from the viewpoint of achieving both suppression of the warpage amount after the bonding and prevention of the occurrence of bubbles at the bonding interface, it can be said that the warpage before the bonding is more preferably in a slightly warped state than in a substantially completely flattened state by the laser irradiation processing.

### (Evaluation method)

The warpage amount shown in Table 6 was measured using a linear gauge. Note that, the warpage amount was verified and confirmed also using a laser interferometer. In addition, the warpage direction when viewed from the non-film formation surface 54 side, which is shown in Table 6, was measured using the laser interferometer.

## Claims

1. A single crystal substrate with a multilayer film, comprising:
a single crystal substrate;
a multilayer film including two or more layers that is formed on one surface of the single crystal substrate; and
a heat-denatured layer provided, of two regions obtained by bisecting the single crystal substrate in a thickness direction of the single crystal substrate, at least in the region on a side of a surface of the single crystal substrate opposite to the one surface having the multilayer film formed thereon.

2. A single crystal substrate with a multilayer film according to claim 1, wherein the heat-denatured layer is formed by laser irradiation to the single crystal substrate.

3. A single crystal substrate with a multilayer film according to claim 1 or 2, wherein the heat-denatured layer is provided in parallel to the multilayer film.

4. A single crystal substrate with a multilayer film according to any one of claims 1 to 3, wherein, when a relative position of the heat-denatured layer in the thickness direction of the single crystal substrate is assumed to be 0% at the one surface provided with the multilayer film and 100% at the surface opposite to the one surface provided with the multilayer film, the heat-denatured layer is provided in a range of more than 50% and 95% or less in the thickness direction of the single crystal substrate.

5. A single crystal substrate with a multilayer film according to any one of claims 1 to 4, wherein, in a planar direction of the single crystal substrate, the heat-denatured layer is provided to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

6. A single crystal substrate with a multilayer film according to claim 5, wherein the shape in which the plurality of polygons identical in shape and size are regularly disposed comprises a lattice shape.

7. A single crystal substrate with a multilayer film according to claim 6, wherein the lattice shape is formed of a pattern in which a pitch between lines constituting the pattern is in a range of 50 µm to 2,000 µm.

8. A single crystal substrate with a multilayer film according to any one of claims 1 to 7, further comprising a second heat-denatured layer provided, when the relative position of the heat-denatured layer in the thickness direction of the single crystal substrate is assumed to be 0% at the one surface provided with the multilayer film and 100% at the surface opposite to the one surface provided with the multilayer film, in a range of 0% or more and less than 50% in the thickness direction of the single crystal substrate.

9. A single crystal substrate with a multilayer film according to any one of claims 1 to 8, wherein a material of the single crystal substrate comprises sapphire.

10. A single crystal substrate with a multilayer film according to any one of claims 1 to 9, wherein the single crystal substrate has a diameter of 50 mm or more and 300 mm or less.

11. A single crystal substrate with a multilayer film according to any one of claims 1 to 10, wherein the single crystal substrate has a thickness of 0.05 mm or more and 5.0 mm or less.

12. A single crystal substrate with a multilayer film according to any one of claims 1 to 11, wherein at least one of the two or more layers constituting the multilayer film comprises a nitride semiconductor crystal layer.

13. A single crystal substrate with a multilayer film according to any one of claims 1 to 12, wherein the multilayer film is subjected to at least a patterning process so as to enable production of an element selected from the group consisting of a light emitting element, a photovoltaic element, and a semiconductor element.

14. A manufacturing method for a single crystal substrate with a multilayer film, comprising performing at least a heat-denatured layer formation step after multilayer film formation in which, of two regions obtained by bisecting, in a thickness direction of a single crystal substrate, the single crystal substrate having one surface on which a multilayer film including two or more layers and having a compressive stress is formed, a heat-denatured layer is formed at least in the region on a side of a surface of the single crystal substrate opposite to the one surface having the multilayer film formed thereon by irradiating a laser from the side of the surface of the single crystal substrate opposite to the one surface having the multilayer film formed thereon.

15. A manufacturing method for a single crystal substrate with a multilayer film according to claim 14, wherein the performing at least a heat-denatured layer formation step after multilayer film formation comprises performing the laser irradiation so as to satisfy at least one of irradiation conditions A and B described below.
<Irradiation Condition A>
• laser wavelength: 200 nm to 350 nm
• pulse width: order of nanoseconds
<Irradiation Condition B>
• laser wavelength: 350 nm to 2,000 nm
• pulse width: order of femtoseconds to order of picoseconds

16. A manufacturing method for a single crystal substrate with a multilayer film according to claim 14 or 15, wherein the performing at least a heat-denatured layer formation step after multilayer film formation comprises forming the heat-denatured layer so as to be in parallel to the multilayer film.

17. A manufacturing method for a single crystal substrate with a multilayer film according to any one of claims 14 to 16, wherein the performing at least a heat-denatured layer formation step after multilayerfilmformation comprises forming the heat-denatured layer to be positioned, when a relative position of the heat-denatured layer in the thickness direction of the single crystal substrate is assumed to be 0% at the one surface provided with the multilayer film and 100% at a surface opposite to the one surface provided with the multilayer film, in a range of more than 50% and 95% or less in the thickness direction of the single crystal substrate.

18. A manufacturing method for a single crystal substrate with a multilayer film according to any one of claims 14 to 17, wherein the performing at least a heat-denatured layer formation step after multilayer film formation comprises forming, in a planar direction of the single crystal substrate, the heat-denatured layer so as to have at least one pattern shape selected from the following shapes:
i) a shape in which a plurality of polygons identical in shape and size are regularly disposed;
ii) a shape inwhichapluralityof circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

19. A manufacturing method for a single crystal substrate with a multilayer film according to claim 18, wherein the shape in which the plurality of polygons identical in shape and size are regularly disposed comprises a lattice shape.

20. A manufacturing method for a single crystal substrate with a multilayer film according to claim 19, wherein the performing at least a heat-denatured layer formation step after multilayer film formation comprises forming the lattice shape into a pattern in which a pitch between lines constituting the pattern is in a range of 50 µm to 2,000 µm.

21. A manufacturing method for a single crystal substrate with a multilayer film according to any one of claims 14 to 20, wherein the performing at least a heat-denatured layer formation step after multilayer film formation comprises, in the following order, at least:
(1) a heat-denatured layer formation step before multilayer film formation in which, by irradiating the laser from a side of the one surface of the single crystal substrate, when a relative position of a heat-denatured layer in the thickness direction of the single crystal substrate is assumed to be 0% at the one surface on the side from which the laser is irradiated and 100% at the surface opposite to the one surface on the side from which the laser is irradiated, the heat-denatured layer is formed so as to be positioned in a range of 0% or more and less than 50% in the thickness direction of the single crystal substrate;
(2) a multilayer film formation step in which the multilayer film including the two or more layers and having the compressive stress is formed on the surface of the single crystal substrate on the side from which the laser is irradiated, the single crystal substrate having the heat-denatured layer formed therein; and
(3) the heat-denatured layer formation step after multilayer film formation.

22. A manufacturing method for a single crystal substrate with a multilayer film according to any one of claims 14 to 21, wherein a material of the single crystal substrate comprises sapphire.

23. A manufacturing method for a single crystal substrate with a multilayer film according to any one of claims 14 to 22, wherein the single crystal substrate has a diameter of 50 mm or more and 300 mm or less.

24. A manufacturing method for a single crystal substrate with a multilayer film according to any one of claims 14 to 23, wherein the single crystal substrate has a thickness of 0.05 mm or more and 5.0 mm or less.

25. A manufacturing method for a single crystal substrate with a multilayer film according to any one of claims 14 to 24, wherein at least one of the two or more layers constituting the multilayer film comprises a nitride semiconductor crystal layer.

26. An element manufacturing method, comprising:
performing at least a heat-denatured layer formation step after multilayer film formation in which, of two regions obtained by bisecting, in a thickness direction of a single crystal substrate, the single crystal substrate having one surface on which a multilayer film including two or more layers and having a compressive stress is formed, a heat-denatured layer is formed at least in the region on a side of a surface of the single crystal substrate opposite to the one surface having the multilayer film formed thereon by irradiating a laser from the side of the surface of the single crystal substrate opposite to the one surface having the multilayer film formed thereon, thereby manufacturing the single crystal substrate with a multilayer film; and
performing at least an element portion formation step of performing at least a patterning process on the multilayer film of the single crystal substrate with a multilayer film to produce an element portion functioning as an element selected from the group consisting of a light emitting element, a photovoltaic element, and a semiconductor element, thereby manufacturing an element including the element portion and the single crystal substrate having a size substantially corresponding to a size of the element portion.
